# EUROPEAN PATENT APPLICATION

(11) **EP 4 819 815 A1**
(43) Date of publication of application: **07.10.2026**
(21) Application number: 24898110.2
(22) Date of filing: 27.11.2024
(51) Int. Cl.: H10K 59/80, H10K 59/131, H10K 59/12, H10K 71/60, H10K 71/16, H10K 71/20, C23C 14/24, C23C 14/56, H10K 59/121

(54) **SYSTEM AND METHOD FOR MANUFACTURING ORGANIC LIGHT-EMITTING DISPLAY DEVICE**

(30) Priority: 28.11.2023 KR 20230167458; 03.09.2024 KR 20240119253; 26.11.2024 KR 20240171525
(71) Applicant: Yas Co., Ltd., Paju-si, Gyeonggi-do 10857 (KR)
(72) Inventor: AHN, Byungchul, Seoul 06574 (KR)
(74) Representative: Epping - Hermann - Fischer
(86) International application number: PCT/KR2024/018943
(87) International publication number: WO 2025/116516

(57) **Abstract**

A manufacturing system for an organic light-emitting display device may comprise a first deposition equipment for forming a first multilayer on a substrate, a first patterning equipment for patterning the first multilayer to form a first organic light-emitting element comprising a first organic light-emitting layer and a first cathode electrode, and forming a first connecting pattern comprising a first extended organic light-emitting layer, a first extended cathode electrode, and a first subpixel protection layer, and a second deposition equipment for forming a second multilayer on the patterned first organic light-emitting element and the first connecting pattern. The patterning of the first multilayer and the formation of the second multilayer may be performed continuously in a vacuum atmosphere in the first patterning equipment and the second deposition equipment.

## Description

### BACKGROUND

### Field of the Disclosure

The present invention relates to an organic light emitting display device, a manufacturing method thereof, and a manufacturing system thereof.

### Discussion of the Related Art

As the demand for portable information media increases, attempts to apply an organic light-emitting display device to various lightweight and thin information electronic devices are expanding. Recently, the organic light-emitting display device is being applied to product groups such as a mobile PC and an automobile rather than a TV or a mobile phone. Since the organic light-emitting display device applied to the mobile PC or the automobile is driven as still image for a long time, long lifespan is required. In order to achieve the long lifespan, the extractions of light from organic light-emitting elements provided in the organic light-emitting display device should be maximized. In addition, in order to reduce costs, it is necessary to expand the technology to enable the production of organic light-emitting elements on a substrate of not only 8.5^{th} generation (2200x2,500mm) but also 10.5^{th} generation (3370x2940mm). In order to produce a long-lifespan organic light-emitting device, each subpixel with a top emission structure and a side-by-side structure must be implemented as an organic light-emitting device structure of two or more stacks.

The structure of such an organic light-emitting device can be obtained through a deposition equipment using a fine metal mask (FMM, hereinafter referred to as FMM). However, the deposition method using FMM has the problem of low productivity because the production logistics must be produced only in a cluster manner, not an in-line manner. In addition, it is impossible to manufacture a substrate larger than 20" due to the size limitation of the FMM mask. In addition, there is a problem of reduced pixel position accuracy (PPA) of the subpixel between the FMM and the substrate. Accordingly, the emission area ratio (EAR) is small, which limits the product lifespan. Here, EAR is the value obtained by dividing the emission area of the subpixel by the total area of the subpixel.

Therefore, the development of a new deposition method and an organic light-emitting display device having a new structure of an organic light-emitting element using the new deposition method to solve the above-mentioned problems is very urgent.

### SUMMARY

An object of the embodiment is to solve the foregoing and other problems.

Another object of the embodiment is to provide an organic light-emitting display device having a new structure.

Another object of the embodiment is to provide an organic light-emitting display device capable of improving lifespan.

Another object of the embodiment is to provide an organic light-emitting display device capable of improving productivity and yield.

Another object of the embodiment is to provide an organic light-emitting display device capable of improving image quality.

Also Another object of the embodiment is to provide a manufacturing method and a manufacturing system for an organic light-emitting display device capable of improving yield and ensuring product reliability.

The technical problems of the embodiments are not limited to those described in this item and comprise those that may be understood through the description of the invention.

According to one aspect of the embodiment to achieve the above or other objects, a manufacturing system for an organic light-emitting display device for sequentially forming a first subpixel, a second subpixel, and a third subpixel constituting a pixel, comprising: a first deposition equipment configured to sequentially deposit a first organic light-emitting film, a first cathode film, and a first insulating film on a substrate to form a first multilayer; a first patterning equipment configured to pattern the formed first multilayer to form a first organic light-emitting element in an emission region of the first subpixel, and to form a first connecting pattern in a non-emission region of the first subpixel -the first organic light-emitting element comprising a first organic light-emitting layer and a first cathode electrode, and the first connecting pattern comprising a first extended organic light-emitting layer extended from the first organic light-emitting layer, a first extended cathode electrode extended from the first cathode electrode, and a first subpixel protection layer-; and a second patterning equipment configured to sequentially deposit a second organic light-emitting film, a second cathode film, and a second insulating film on the patterned first organic light-emitting element and the first connecting pattern to form a second multilayer, wherein the patterning of the first multilayer and the forming of the second multilayer are performed continuously in a vacuum atmosphere in the first patterning equipment and the second patterning equipment.

The second patterning equipment may form the second multilayer on a lateral surface of the first extended cathode electrode exposed by the patterning of the first multilayer.

The first patterning equipment may comprise a cluster chamber having a robot arm; and a plurality of chambers installed in a ring shape around the cluster chamber and configured to pattern the formed first multilayer.

The second patterning equipment may comprise an organic light-emitting chamber configured to be connected to the first patterning equipment, comprising a plurality of sub-chambers arranged in an in-line manner, and configured to deposit the second organic light-emitting film; a cathode chamber installed in a same direction as the plurality of sub-chambers and configured to deposit the second cathode film; a cluster chamber connected to the cathode chamber and having a robot arm; and a plurality of chambers installed in a ring shape around the cluster chamber and configured to deposit the second insulating film.

The manufacturing system may further comprise a second patterning equipment configured to pattern the formed second multilayer to form a second organic light-emitting element in an emission region of the second subpixel, and to form a second connecting pattern in an non-emission region of the second subpixel -the second organic light-emitting element comprising a second organic light-emitting layer and a second cathode electrode, and the second connecting pattern comprising a second extended organic light-emitting layer extended from the second organic light-emitting layer, a second extended cathode electrode extended from the second cathode electrode, and a second subpixel protection layer-; and a third deposition equipment configured to sequentially deposit a third organic light-emitting film, a third cathode film, and a third insulating film on the patterned second organic light-emitting element and the second connecting pattern to form a third multilayer. The patterning of the second multilayer and the forming of the third multilayer may be performed continuously in a vacuum atmosphere in the second patterning equipment and the third deposition equipment.

The third patterning equipment may form the third multilayer on a lateral surface of the second extended cathode electrode exposed by the patterning of the second multilayer.

The second patterning equipment may comprise a cluster chamber having a robot arm; and a plurality of chambers installed in a ring shape around the cluster chamber and configured to pattern the formed second multilayer.

The third patterning equipment may comprise an organic light-emitting chamber connected to the second patterning equipment, comprising a plurality of sub-chambers arranged in an in-line manner, and configured to deposit the third organic light-emitting film; a cathode chamber installed in a same direction as the plurality of sub-chambers and configured to deposit the third cathode film; a cluster chamber connected to the cathode chamber and having a robot arm; and a plurality of chambers installed in a ring shape around the cluster chamber and configured to deposit the third insulating film.

The manufacturing system may further comprise a third patterning equipment configured to pattern the formed third multilayer to form a third organic light-emitting element in an emission region of the third subpixel, and to form a third connecting pattern in a non-emission region of the third subpixel -the third organic light-emitting element comprising a third organic light-emitting layer and a third cathode electrode, and the third connecting pattern comprising a third extended organic light-emitting layer extended from the third organic light-emitting layer, a third extended cathode electrode extended from the third cathode electrode, and a third subpixel protection layer-; and a fourth deposition equipment configured to deposit a pixel protection layer on the patterned third organic light-emitting element and the third connecting pattern.

The patterning of the third multilayer and the deposition of the pixel protection layer may be performed continuously in a vacuum atmosphere in the third patterning equipment and the fourth deposition equipment.

The fourth deposition equipment may form the pixel protection layer on a lateral surface of the first extended cathode electrode, a lateral surface of the second extended cathode electrode, and a lateral surface of the third extended cathode electrode exposed by the patterning of the third multilayer.

The third patterning equipment may comprise a cluster chamber having a robot arm; and a plurality of chambers installed in a ring shape around the cluster chamber and configured to pattern the formed third multilayer.

The manufacturing system may further comprise a fourth patterning equipment configured to pattern the pixel protection layer and the first subpixel protection layer to the third subpixel protection layer to form a power contact hole of a power connecting structure in which power wiring is exposed and a first cathode contact hole to a third cathode contact hole in which the first extended cathode electrode to the third extended cathode electrode are exposed; and a fifth deposition equipment configured to deposit a bridge electrode on the substrate comprising the power contact hole and the first cathode contact hole to the third cathode contact hole. The patterning of the pixel protection layer and the deposition of the bridge electrode may be performed continuously in a vacuum atmosphere in the fourth patterning equipment and the fifth deposition equipment.

The fifth patterning equipment may form the bridge electrode on an upper surface of the first extended cathode electrode, a lateral surface of the second extended cathode electrode, and a lateral surface of the third extended cathode electrode, which are exposed through the power contact hole and the first cathode contact hole to the third cathode contact hole, by patterning the pixel protection layer.

The manufacturing system may further comprise a fifth patterning equipment configured to pattern the bridge electrode; and a sixth patterning equipment configured to deposit an encapsulation layer on the substrate comprising the patterned bridge electrode. The patterning of the bridge electrode and the deposition of the encapsulation layer may be performed continuously in a vacuum atmosphere in the fifth patterning equipment and the sixth patterning equipment.

The first subpixel protection layer, the second subpixel protection layer, and the third subpixel protection layer may be formed in the emission region of the first subpixel, the emission region of the second subpixel, and the emission region of the third subpixel, respectively.

According to another aspect of the embodiment to achieve the above or other objects, a manufacturing method for an organic light-emitting display device for sequentially forming a first subpixel, a second subpixel, and a third subpixel constituting a pixel, comprising: sequentially depositing a first organic light-emitting film, a first cathode film, and a first insulating film on a substrate to form a first multilayer; patterning the formed first multilayer to form a first organic light-emitting element in the emission region of the first subpixel, and to form a first connecting pattern in the non-emission region of the first subpixel -the first organic light-emitting element comprising a first organic light-emitting layer and a first cathode electrode, and the first connecting pattern comprising a first extended organic light-emitting layer extended from the first organic light-emitting layer, a first extended cathode electrode extended from the first cathode electrode, and a first subpixel protection layer-; and sequentially depositing a second organic light-emitting film, a second cathode film, and a second insulating film on the patterned first organic light-emitting element and the first connecting pattern to form a second multilayer, wherein the patterning of the first multilayer and the film formation of the second multilayer may be performed continuously in a vacuum atmosphere.

The forming the second multilayer may comprise forming the second multilayer on a lateral surface of the first extended cathode electrode exposed by the patterning of the first multilayer.

The manufacturing method may further comprise patterning the formed second multilayer to form a second organic light-emitting element in an emission region of the second subpixel, and to form a second connecting pattern in a non-emission region of the second subpixel -the second organic light-emitting element comprising a second organic light-emitting layer and a second cathode electrode, and the second connecting pattern comprising a second extended organic light-emitting layer extended from the second organic light-emitting layer, a second extended cathode electrode extended from the second cathode electrode, and a second subpixel protection layer-; and sequentially depositing a third organic light-emitting film, a third cathode film, and a third insulating film on the patterned second organic light-emitting element and the second connecting pattern to form a third multilayer. The patterning of the second multilayer and the formation of the third multilayer may be performed continuously in a vacuum atmosphere.

The forming the third multilayer may comprise forming the third multilayer on a lateral surface of the second extended cathode electrode exposed by the patterning of the second multilayer.

The manufacturing method may further comprise patterning the formed third multilayer to form a third organic light-emitting element in an emission region of the third subpixel, and to form a third connecting pattern in a non-emission region of the third subpixel -the third organic light-emitting element comprising a third organic light-emitting layer and a third cathode electrode, and the third connecting pattern comprising a third extended organic light-emitting layer extended from the third organic light-emitting layer, a third extended cathode electrode extended from the third cathode electrode, and a third subpixel protection layer-; and depositing a pixel protection layer on the patterned third organic light-emitting element and the third connecting pattern. The patterning of the third multilayer and the deposition of the pixel protection layer may be performed continuously in a vacuum atmosphere.

The forming the pixel protection layer may comprise forming the pixel protection layer on a lateral surface of the first extended cathode electrode, a lateral surface of the second extended cathode electrode, and a lateral surface of the third extended cathode electrode exposed by the patterning of the third multilayer.

The manufacturing method may further comprise patterning the pixel protection layer and the first subpixel protection layer to the third subpixel protection layer to form a power contact hole of a power connecting structure in which power wiring is exposed and a first cathode contact hole to a third cathode contact hole in which the first extended cathode electrode to the third extended cathode electrode are exposed; and depositing bridge electrode on the substrate comprising the power contact hole and the first cathode contact hole to the third cathode contact hole. The patterning of the pixel protection layer and the deposition of the bridge electrode may be performed continuously in a vacuum atmosphere.

The forming the bridge electrode may comprise forming the bridge electrode on an upper surface of the first extended cathode electrode, a lateral surface of the second extended cathode electrode, and a lateral surface of the third extended cathode electrode, which are exposed through the power contact hole and the first cathode contact hole to the third cathode contact hole, by patterning the pixel protection layer.

The manufacturing method may further comprise patterning the bridge electrode; and forming an encapsulation layer on the substrate comprising the patterned bridge electrode. The patterning of the bridge electrode and the deposition of the encapsulation layer may be performed continuously in a vacuum atmosphere.

The effect of the organic light-emitting display device according to the embodiment is described as follows.

According to at least one of the embodiments, there is an advantage that the process can be simplified and the process cost can be reduced because there is no need to use an FMM.

According to at least one of the embodiments, there is an advantage that the EAR within the subpixel may be increased because there is no need to use an FMM, so that the lifespan can be improved.

According to at least one of the embodiments, there is an advantage that the productivity, yield, and material utilization efficiency can be improved by depositing an organic light-emitting element on a large-area substrate in an in-line deposition system.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### BRIEF DESCRIPTION OF THE DRAWINGS

FIG. 1 is a plan view illustrating an organic light-emitting display device according to a first embodiment.
FIG. 2A is a plan view illustrating an organic light-emitting display device according to a second embodiment.
FIG. 2B is a plan view illustrating an organic light-emitting display device according to a third embodiment.
FIGS. 3A and 3B schematically illustrate pixel structures according to the comparative example and the embodiment.
FIG. 4 is a cross-sectional view illustrating an organic light-emitting display device according to a fourth embodiment.
FIG. 5 is a cross-sectional view illustrating an organic light-emitting display device according to a fifth embodiment.
FIG. 6 is a cross-sectional view illustrating an organic light-emitting display device according to a sixth embodiment.
FIG. 7 is a plan view illustrating an organic light-emitting display device according to a seventh embodiment.
FIG. 8 is a cross-sectional view illustrating an organic light-emitting display device according to an eighth embodiment.
FIG. 9 is a cross-sectional view illustrating an organic light-emitting display device according to a ninth embodiment.
FIG. 10 is a plan view illustrating an organic light-emitting display device according to a tenth embodiment.
FIG. 11 is a plan view illustrating an organic light-emitting display device according to an eleventh embodiment.
FIG. 12 is a cross-sectional view illustrating an organic light-emitting display device according to a twelfth embodiment.
FIG. 13 is a cross-sectional view illustrating a third subpixel of an organic light-emitting display device according to a thirteenth embodiment.
FIG. 14 is a cross-sectional view illustrating one pixel of an organic light-emitting display device according to a fourteenth embodiment.
FIG. 15 illustrates a procedure of a manufacturing process of an organic light-emitting display device according to an embodiment.
FIG. 16 illustrates a manufacturing system of an organic light-emitting display device according to an embodiment.
FIGS. 17A to 17Q are cross-sectional views illustrating a manufacturing process of an organic light-emitting display device.
FIG. 18A and FIG. 18B are a plan view and a cross-sectional view of an organic light-emitting display device according to a fifteenth embodiment.

The sizes, shapes, dimensions, etc., of elements illustrated in the drawings may differ from actual ones. In addition, even if the same elements are illustrated in different sizes, shapes, dimensions, etc., between the drawings, this is only an example on the drawing, and the same elements have the same sizes, shapes, dimensions, etc., between the drawings.

### DETAILED DESCRIPTION

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

As described above, in order to solve the problems in the deposition method using FMM, a new way of forming a subpixel structure, a manufacturing process, and a manufacturing system for the same are proposed.

In the embodiment, each subpixel constituting a pixel may be formed using photolithography (hereinafter referred to as photo) and etching. Accordingly, the aperture ratio may be increased, so that the luminance and lifespan can be improved. In addition, since it is possible to manufacture a large-area substrate corresponding to the 10.5 generation, it is possible to manufacture a panel of 100" or larger. In addition, since the manufacturing system is configured in an in-line manner, productivity can be improved.

Meanwhile, as the size of the substrate increases, the length of the power wiring on the substrate may also increase. The voltage drop due to the increase in the length of the power wiring increases, which may cause a decrease in luminance or brightness and result in poor image quality.

Accordingly, in a substrate of a certain size, for example, 20" or larger, an electrical contact structure between the subpixels and the power wiring is provided at several locations on the substrate, so that the voltage drop can minimized and a decrease in luminance or brightness can be prevented, thereby improving the image quality.

In an embodiment, a plurality of subpixels constituting a pixel may be formed using photo and etching, and an electrical connecting structure between the power wiring and each subpixel may be formed.

This structure may be implemented by the unique technology of the present invention, that is, a manufacturing process in which patterning of a current subpixel and deposition of a next subpixel are performed continuously in a vacuum atmosphere, and a manufacturing system for performing the same. In addition, the structure may be implemented by a manufacturing process in which patterning of a contact hole and a bridge electrode deposition, and patterning of a bridge electrode and an encapsulation layer deposition are performed continuously in a vacuum atmosphere, and a manufacturing system for performing the same.

Therefore, even if a cathode electrode or an extended cathode electrode exposed by the patterning of the current subpixel is covered by the deposition of the next subpixel and exposed to the atmosphere for a photo process as a subsequent process, the cathode electrode or the extended cathode electrode may not be oxidized by oxygen in the atmosphere. In addition, even if the cathode electrode or the extended cathode electrode exposed by the patterning of the contact hole is covered by the deposition of the bridge electrode and exposed to the atmosphere for a photo process as a subsequent process, the cathode electrode or the extended cathode electrode may not be oxidized by oxygen in the atmosphere. In addition, by continuously forming an encapsulation layer while maintaining a vacuum with the cathode electrode or the extended cathode electrode exposed by the patterning of the bridge electrode, not only is the cathode electrode not oxidized in the atmosphere, it may be also covered by an encapsulation layer. Accordingly, even if it is exposed to the atmosphere for a photo process as a subsequent process, the cathode electrode or the extended cathode electrode may not be oxidized by oxygen in the atmosphere.

In addition, while maintaining a vacuum in a state where the cathode electrode is exposed, a reverse voltage may be applied to the organic light-emitting element in an atmosphere containing a small amount of oxygen or moisture.

In a subpixel in which the organic light-emitting element has electrical leakage or is short-circuited and has become a dark spot, the cathode electrode is partially oxidized or removed by overcurrent.

Through this process, the dark-spot subpixel is repaired back to normal subpixels. The yield can be improved by drastically reducing the number of dark spots per panel (from 100 to 3), which is a key specification for a good panel.

The above-described manufacturing process may be implemented by a manufacturing system configured in an in-line manner. Accordingly, productivity, yield, and material utilization efficiency can be improved.

Hereinafter, an organic light-emitting display device, a manufacturing method thereof, and a manufacturing system thereof will be described in detail.

### [Organic light-emitting display device]

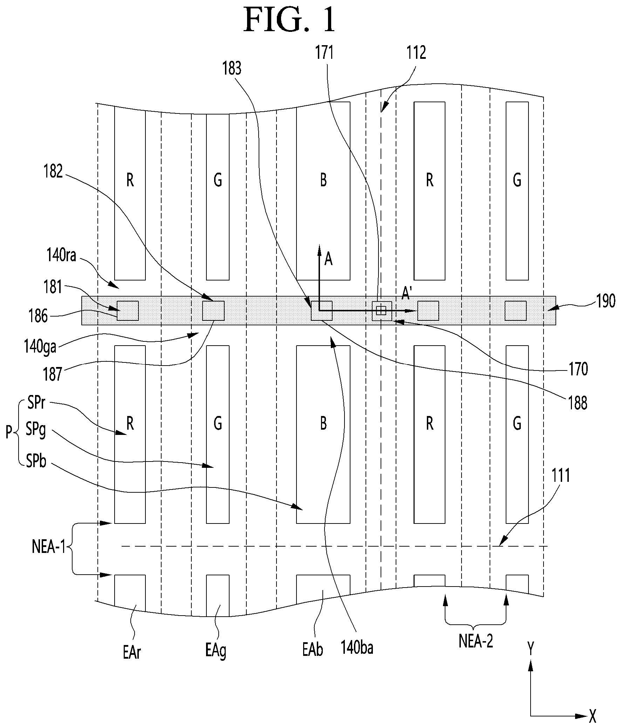

FIG. 1 is a plan view illustrating an organic light-emitting display device according to a first embodiment.

As illustrated in FIG. 1, the organic light-emitting display device according to the first embodiment may comprise a plurality of pixels P arranged in a matrix. A plurality of pixels P may be arranged in a display region. The remaining region excluding the display region may be defined as a non-display region. A non-display region may be provided along a bezel region of the substrate 100.

The plurality of pixels P may comprise, for example, a plurality of first subpixels SPr, a plurality of second subpixels SPg, a plurality of third subpixels SPb, etc. The plurality of subpixels SPr, SPg, and SPb may have different colors along a first direction X and the same color along a second direction Y intersecting the first direction X, but is not limited thereto. That is, the plurality of subpixels SPr, SPg, and SPb may have the same color along the second direction Y and have a long stripe pattern (or stripe shape).

The first subpixel SPr, the second subpixel SPg, and the third subpixel SPb may each comprise an emission region EAr, EAg, and EAb, and a non-emission region NEA-1 and NEA-2. The non-emissive regions NEA-1 and NEA-2 may surround the emissive regions EAr, EAg, and EAb.

A first organic light-emitting element 140r may be disposed in the first subpixel SPr, a second organic light-emitting element 140g may be disposed in the second subpixel SPg, and a third organic light-emitting element 140b may be disposed in the third subpixel SPb. The first organic light-emitting element 140r may emit a first color light, the second organic light-emitting element 140g may emit a second color light, and the third organic light-emitting element 140b may emit a third color light. The first color light may be red light, the second color light may be green light, and the third color light may be blue light.

The first organic light-emitting device 140r, the second organic light-emitting device 140g, and the third organic light-emitting device 140b may each comprise an anode electrode, an organic light-emitting layer, and a cathode electrode.

The organic light-emitting layer may comprise a hole injection layer, a hole transport layer, an organic emission layer, an electron transport layer, an electron injection layer, a charge generation layer, etc. The first organic light-emitting device 140r, the second organic light-emitting device 140g, and the third organic light-emitting device 140b may each comprise at least two or more organic light-emitting stack structures. Each organic light-emitting stack structure comprises an organic emission layer that emits light, and a charge generation layer may be provided between the two or more organic light-emitting stack structures.

The anode electrodes may be disposed in the emission region EAr of the first subpixel SPr, the second subpixel SPg, and the third subpixel SPb, respectively. The areas of the emission regions EAr, EAg, and EAb may be determined by the areas of the anode electrodes in contact with the organic light-emitting layers, but is not limited thereto.

For example, the organic light-emitting layer and the cathode electrode may have a stripe pattern having the same color and being disposed long along the second direction Y. For example, the first organic light-emitting layer 142r and the first cathode electrode 143r of the first organic light-emitting element 140r may be arranged in a stripe shape along the second direction Y. For example, the second organic light-emitting layer 142g and the second cathode electrode 143g of the second organic light-emitting element 140g may be arranged in a stripe shape along the second direction Y. For example, the third organic light-emitting layer 142b and the third cathode electrode 143b of the third organic light-emitting element 140b may be arranged in a stripe shape along the second direction Y.

The first subpixel SPr, the second subpixel SPg, and the third subpixel SPb may be alternately disposed in a column-line unit along the first direction X, thereby implementing an organic light-emitting display device having a side-by-side structure. For example, they may be alternately arranged in the order of the first subpixel SPr, the second subpixel SPg, and the third subpixel SPb along the first direction X, but is not limited thereto. Alternatively, they may be alternately arranged in the order of the first organic light-emitting element 140r, the second organic light-emitting element 140g, and the third organic light-emitting element 140b along the first direction X.

The areas of the emission region EAr of the first subpixel SPr, the second subpixel SPg, and the third subpixel SPb, respectively, may be different. For example, the luminous efficiency of the third organic light-emitting element 140b may be lower than the luminous efficiency of the first organic light-emitting element 140r or the second organic light-emitting element 140g. In this instance, the area of the emission region EAb of the third subpixel SPb is designed to be greater than the area of the emission region EAr of the first subpixel SPr or the area of the emission region EAg of the second subpixel SPg, so that it makes the lifespans of the first organic light-emitting element 140r, the second organic light-emitting element 140g and the third organic light-emitting element 140b uniform, thereby improving the brightness of the product.

Meanwhile, the power wirings 111 and 112 may be disposed in the display region through the non-display region. A low voltage or low voltage may be supplied to the power wirings 111 and 112. The low voltage or low voltage may be, for example, 0 V or a voltage near it. Although not illustrated, another wiring may be disposed in the display region and the non-display region. A high voltage or high voltage may be supplied to another power wiring.

The power wirings 111 and 112 may be arranged in a matrix form in the display region, but are not limited thereto. The power wirings 111 and 112 disposed in the non-display region and the power wirings 111 and 112 disposed in the display region may be disposed in different layers, but are not limited thereto. In this instance, at least one or more of the power wirings 111 and 112 disposed in the display region may extend to the non-display region and be electrically connected to the power wirings 111 and 112 disposed in the non-display region through a via hole in the non-display region. The power wirings 111 and 112 arranged in the display region may be called auxiliary electrodes. The power wirings 111 and 112 may be disposed on the same layer as the anode electrode, but are not limited thereto.

Meanwhile, a first connecting pattern 140ra, a second connecting pattern 140ga, and a third connecting pattern 140ba may be disposed to extend from the emission regions EAr, EAg, and EAb to the non-emission region NEA-1 and NEA-2, respectively.

The second power wiring 112 may be electrically connected to the first organic light-emitting element 140r, the second organic light-emitting element 140g, and the third organic light-emitting element 140b through the first connecting pattern 140ra to the third connecting pattern 140ba.

The bridge electrode 190 may have a bar shape that is disposed long along one direction X.

The bridge electrode 190 may be disposed on the first connecting pattern 140ra to the third connecting pattern 140ba, so that the second power wiring 112 and the first connecting pattern 140ra to the third connecting pattern 140ba may be electrically connected through the bridge electrode 190. The bridge electrode 190 may not be disposed on the emission region EAr, EAg, and EAb of the first subpixel SPr to the third subpixel SPb, that is, the first organic light-emitting element 140r to the third organic light-emitting element 140b. The bridge electrode 190 may not vertically overlap the first organic light-emitting element 140r to the third organic light-emitting element 140b, but may vertically overlap the first connecting pattern 140ra to the third connecting pattern 140ba. Accordingly, an emission area ratio (EAR) may be increased. Meanwhile, when the bridge electrode 190 is formed of a transparent conductive film, the bridge electrode 190 may be disposed in a part or the entire region of the first subpixel SPr to the third subpixel SPb.

A power connecting structure 170 may be disposed under a bank 120 at the intersection region of the non-emission region NEA-1 in the first direction X and the non-emission region NEA-2 in the second direction Y.

A first cathode connecting structure 181 to a third cathode connecting structure 183 may be disposed on the bank 120, respectively. The first cathode connecting structure 181 may be disposed on the bank 120 between the first subpixels SPr adjacent in the second direction Y. The second cathode connecting structure 182 may be disposed on the bank 120 between the second subpixels SPg adjacent in the second direction Y. The third cathode connecting structure 183 may be disposed on the bank 120 between the third subpixels SPb adjacent in the second direction Y.

The power connecting structure 170 may be disposed on the power wirings 111 and 112 at the intersection region of the non-emission region NEA-1 in the first direction X and the non-emission region NEA-2 in the second direction Y, and the first cathode connecting structure 181 to the third cathode connecting structure 183 may be disposed on the first connecting pattern 140ra to the third connecting pattern 140ba.

The first cathode connecting structure 181 may be disposed on the first connecting pattern 140ra in the second direction Y, the second cathode connecting structure 182 may be disposed on the second connecting pattern 140ga in the second direction Y, and the third cathode connecting structure 183 may be disposed on the third connecting pattern 140ba in the second direction Y.

The bridge electrode 190 may be electrically connected to the power wirings 111 and 112 through the power connecting structure 170, and may be electrically connected to the first connecting pattern 140ra to the third connecting pattern 140ba through the first cathode connecting structure 181 to the third cathode connecting structure 183.

The bridge electrode 190 may be made of a conductive material having excellent electrical conductivity. For example, the bridge electrode 190 may comprise aluminum (Al), molybdenum (Mo), etc. For example, the bridge electrode 190 may comprise an alloy such as MoTi, in which aluminum (Al) or molybdenum (Mo) is a main component. For example, the bridge electrode 190 may be a transparent conductive film such as ITO or IZO.

The bridge electrode 190 may be disposed across the first cathode connecting structure 181 to the third cathode connecting structure 183 along the first direction X.

Although not illustrated, the bridge electrode 190 may be disposed in a matrix form while being connected to a plurality of power contact holes 171 along the second direction Y. Accordingly, the resistance of the power wirings 111 and 112 can be further reduced, thereby improving the image quality.

In addition, although not illustrated, when the photoresist resin made of black resin is not stripped (or removed) after the patterning is completed for patterning the bridge electrode 190 and the bridge electrode 190 is covered by the photoresist resin made of black resin, the reflected light can be reduced, so that light leakage can be reduced and the image quality, such as the contrast ratio, can be improved.

Therefore, the power wirings 111 and 112 with the low voltage may be electrically connected to the first organic light-emitting element 140r, the second organic light-emitting element 140g, and the third organic light-emitting element 140b through the bridge electrode 190 and the first connecting pattern 140ra to the third connecting pattern 140ba.

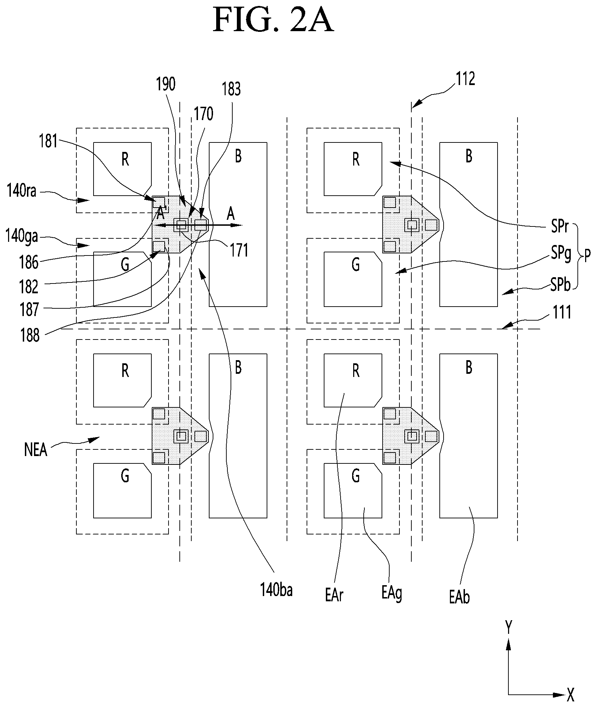

FIG. 2A is a plan view illustrating an organic light-emitting display device according to a second embodiment.

The second embodiment is the same as the first embodiment (FIG. 1) except for the arrangement structure of the plurality of subpixels SPr, SPg, and SPb. In the second embodiment, components having the same shape, structure, and/or function as those in the first embodiment (FIG. 1) are given the same drawing reference numerals and detailed descriptions are omitted.

As illustrated in FIG. 2A, the plurality of pixels P may each comprise a plurality of first subpixels SPr, a plurality of second subpixels SPg, a plurality of third subpixels SPb, etc.

The first subpixels SPr to the third subpixels SPb may have a structure in which a dot shape and a stripe shape are mixed.

The first subpixels SPr and the second subpixels SPg may each be disposed in a dot shape. The plurality of first subpixels SPr may be arranged along the second direction Y. The plurality of second subpixels SPg may be arranged between the plurality of first subpixels SPr along the second direction Y. That is, they may be alternately arranged in the order of the first subpixels SPr and the second subpixels SPg along the second direction Y.

The plurality of third subpixels SPb may have a stripe pattern (or stripe shape) having the same color and disposed long along the second direction Y. The plurality of third subpixels SPb may be arranged parallel to the plurality of first subpixels SPr and the plurality of second subpixels SPg along the second direction Y. For example, an area of the third subpixel SPb may be equal to or similar to the sum of an area of the first subpixel SPr and an area of the second subpixel SPg.

The first subpixel SPr, the second subpixel SPg, and the third subpixel SPb may each comprise an emission region EAr, EAg, and EAb and a non-emission region NEA. The non-emission region NEA may surround the emission region EAr, EAg, and EAb.

The first organic light-emitting element 140r may be disposed in the first subpixel SPr, the second organic light-emitting element 140g may be disposed in the second subpixel SPg, and the third organic light-emitting element 140b may be disposed in the third subpixel SPb.

The first organic light-emitting device 140r, the second organic light-emitting device 140g, and the third organic light-emitting device 140b may each comprise an anode electrode, an organic light-emitting layer, and a cathode electrode.

The anode electrodes of the first organic light-emitting device 140r, the second organic light-emitting device 140g, and the third organic light-emitting device 140b may be individually disposed in the emission region EAr of the first subpixel SPr, the emission region EAg of the second subpixel SPg, and the emission region EAb of the third subpixel SPb, respectively.

The organic light-emitting layer and the cathode electrode of the first organic light-emitting element 140r and the second organic light-emitting element 140g may be individually disposed in the emission region EAr of the first subpixel SPr and the emission region EAg of the second subpixel SPg. The organic light-emitting layer and the cathode electrode of the third organic light-emitting element 140b may be disposed in a stripe shape along the second direction Y. That is, the organic light-emitting layer and the cathode electrode of the third organic light-emitting element 140b may be disposed in the emission regions EAb of the plurality of third subpixels SPb as well as in the non-emission region NEA along the second direction Y.

Meanwhile, the first connecting pattern 140ra, the second connecting pattern 140ga, and the third connecting pattern 140ba may be disposed to extend from the emission regions EAr, EAg, and EAb to the non-emission region NEA, respectively.

The first cathode connecting structure 181, the second cathode connecting structure 182, and the third cathode connecting structure 183 may each be positioned at a closest distance from the power connecting structure 170.

The first cathode connecting structure 181 may be disposed on the first connecting pattern 140ra along a first diagonal direction, and the second cathode connecting structure 182 may be disposed on the second connecting pattern 140ga along a second diagonal direction. The second diagonal direction may be a direction rotated 90 degrees counterclockwise with respect to the first diagonal direction. The third cathode connecting structure 183 may be disposed on the third connecting pattern 140ba along a horizontal direction between the first subpixel SPr and the second subpixel SPg.

The second power wiring 112 may be electrically connected to the first organic light-emitting element 140r of the first subpixel SPr, the second organic light-emitting element 140g of the second subpixel SPg, and the third organic light-emitting element 140b of the third subpixel SPb through the first connecting pattern 140ra to the third connecting pattern 140ba.

The bridge electrode 190 may be individually disposed on the plurality of pixels P. The bridge electrode 190 may be disposed in a dot shape or a pattern shape on each pixel.

The bridge electrode 190 may be disposed on the first connecting pattern 140ra to the third connecting pattern 140ba, so that the second power wiring 112 and the first connecting pattern 140ra to the third connecting pattern 140ba may be electrically connected through the bridge electrode 190.

The power connecting structure 170 may be provided on the power wirings 111 and 112, and the first cathode connecting structure 181 to the third cathode connecting structure 183 may be provided on the first connecting pattern 140ra to the third connecting pattern 140ba.

The bridge electrode 190 may be electrically connected to the power wirings 111 and 112 through the power connecting structure 170, and may be electrically connected to the first connecting pattern 140ra to the third connecting pattern 140ba through the first cathode connecting structure 181 to the third cathode connecting structure 183.

The bridge electrode 190 may be disposed to cover the first cathode connecting structure 181 to the third cathode connecting structure 183, which are spaced as close as possible from the power connecting structure 170.

Therefore, the power wirings 111 and 112 with the low voltage may be electrically connected to the first organic light-emitting element 140r, the second organic light-emitting element 140g, and the third organic light-emitting element 140b through the bridge electrode 190 and the first connecting pattern 140ra to the third connecting pattern 140ba.

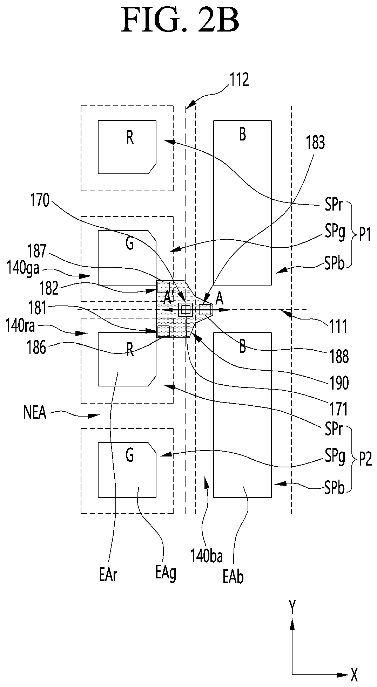

FIG. 2B is a plan view illustrating an organic light-emitting display device according to a third embodiment. FIG. 2B is identical to the second embodiment (FIG. 2A) except for the position of the power connecting structure 170.

As illustrated in FIG. 2B, the power connecting structure 170 may be disposed in a crossroad region(or four-way region) where four subpixels meet. Among the four subpixels, the second subpixel SPg and the third subpixel SPb may be included in the first pixel P1, and the first subpixel SPr and the third subpixel SPb may be included in the second pixel P2. The first pixel P1 and the second pixel P2 may be positioned adjacent to each other. This arrangement structure of the power connecting structure 170 may be advantageous for the arrangement of the power connecting structure 170 since there is a lot of free space in crossroad region and the power wiring 112 may easily cross in the first direction X and the second direction Y.

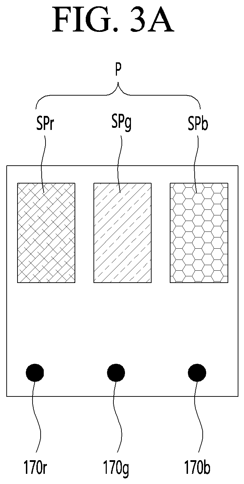

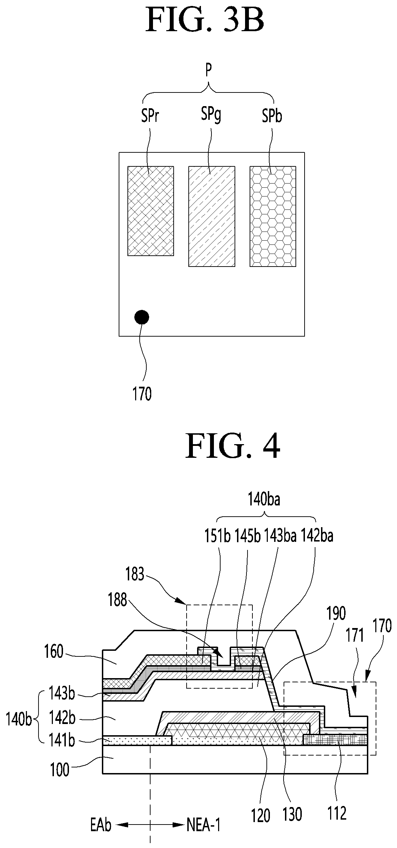

FIGS. 3A and 3B schematically illustrate pixel structures according to the comparative example and the embodiment.

In the comparative example (FIG. 3A), three power connecting structures 170r, 170g, and 170b are provided in one pixel, whereas in the embodiment (FIG. 3B), one power connecting structure 170 may be provided in one pixel.

In the comparative example (FIG. 3A), the first power connecting structure 170r, the second power connecting structure 170g, and the third power connecting structure 170b may be electrically connected to the first subpixel SPr, the second subpixel SPg, and the third subpixel SPb, respectively. In contrast, in the embodiment (FIG. 3B), one power connecting structure 170 may be commonly connected to three subpixels SPr, SPg, and SPb.

For example, when 100 pixels are provided on the substrate 100, 300 power connecting structures 170 may be formed in the comparative example (FIG. 3A), whereas 100 power connecting structures 170 may be formed in the embodiment (FIG. 3B).

Therefore, since the embodiment only needs to form 1/3 of the power connecting structures 170 compared to the comparative example, the aperture ratio can be increased, thereby improving brightness and lifespan. In addition, since the embodiment only needs to form 1/3 of the power connecting structures 170 compared to the comparative example, the structure can be simplified, and the process time and process cost can be reduced. In addition, since the embodiment only needs to form 1/3 of the power connecting structures 170 compared to the comparative example, defects in the manufacturing process can be prevented. FIG. 4 illustrates a connecting structure between the third subpixel SPb and the power wirings 111 and 112 along the A-A' lines of FIGS. 1, 2A, and 2B, respectively. Although not illustrated, the connecting structure between the first subpixel SPr and the power wirings 111 and 112 and the connecting structure between the second subpixel SPg and the power wirings 111 and 112 may be the same as the connecting structure between the third subpixel SPb and the power wirings 111 and 112.

Referring to FIG. 4, the organic light-emitting display device according to the fourth embodiment may comprise a bank 120, a third organic light-emitting element 140b, a third connecting pattern 140ba, a power connecting structure 170, a third cathode connecting structure 183, a bridge electrode 190, etc.

The third subpixel SPb may be provided on the substrate 100. The third subpixel SPb may comprise an emission region EAb and a non-emission region NEA-1 and NEA-2.

The third organic light-emitting element 140b may be disposed in the third subpixel SPb. The third organic light-emitting element 140b may comprise a third anode electrode 141b, a third organic light-emitting layer 142b, a third cathode electrode 143b, etc.

The third anode electrode 141b may be disposed in the emission region EAb of each of the plurality of third subpixels SPb. Accordingly, the third anode electrodes 141b disposed in the emission region EAb of the third subpixels SPb adjacent to each other may be disposed to be spaced apart from each other.

As illustrated in FIG. 1, the third organic light-emitting layer 142b and the third cathode electrode 143b may be disposed in a stripe shape along the second direction Y. In this instance, the third organic light-emitting layer 142b and the third cathode electrode 143b may be disposed not only in the emission region EAb of the plurality of, but also in the non-emission region NEA-1 and NEA-2 third subpixels SPb along the second direction Y.

The power wirings 111 and 112 may be disposed on the substrate 100.

Although not illustrated, a third driving circuit and an interlayer-insulating layer may be disposed on the substrate 100. The interlayer-insulating layer may be referred to as a protective layer, a planarization layer, etc. The third driving circuit may be electrically connected to the anode electrode of the third organic light-emitting element 140b through a through hole of the interlayer-insulating layer.

A bank 120 may be disposed on the substrate 100. The bank 120 may be disposed on the power wirings 111 and 112.

The third anode electrodes 141b and the power wirings 111 and 112 may be disposed on the same layer. The third anode electrodes 141b and the power wirings 111 and 112 may be formed simultaneously using the same photo and etching with the same material, but is not limited thereto. The power wirings 111 and 112 may be electrically connected to power wirings formed together with the gate electrode or the drain electrode of the third driving circuit through the through hole of the interlayer-insulating layer. The power wirings 111 and 112 disposed on the interlayer-insulating layer may be called auxiliary electrodes, and the power wirings disposed below the interlayer-insulating layer may be called main power wirings. The power wirings may extend from the display region to the non-display region and be electrically connected to another main power wirings connected to an input terminal in the non-display region, but are not limited thereto.

The bank 120 may be disposed in the non-emission region NEA-1 and NEA-2 of the plurality of third subpixels SPb adjacent to each other. The bank 120 may be disposed in the non-emission region NEA-1 and NEA-2 of the first subpixel SPr, the second subpixel SPg, and the third subpixel SPb, respectively. As illustrated in FIG. 1, the bank 120 may be arranged in a matrix in the non-emission region NEA-1 and NEA-2 of the first subpixel SPr, the second subpixel SPg, and the third subpixel SPb, respectively, along the first direction X and the second direction Y. As illustrated in FIGS. 2A and 2B, the bank 120 may be arranged in a matrix in the non-emission region NEA of the first subpixel SPr, the second subpixel SPg, and the third subpixel SPb, respectively.

Meanwhile, the third connecting pattern 140ba may be disposed on the non-emission region NEA-1 and NEA-2 of the third subpixel SPb. The third connecting pattern 140ba may be disposed on the bank 120 and may be disposed to extend from the emission region EAb of the third subpixel SPb to the non-emission region NEA-1 and NEA-2.

The third connecting pattern 140ba may comprise a third extended organic light-emitting layer 142ba, a third extended cathode electrode 143ba, a third cathode protective layer 145b, and a third subpixel protective layer 151b. The third extended organic light-emitting layer 142ba may be disposed on the bank 120, and the third extended cathode electrode 143ba may be disposed on the third extended organic light-emitting layer 142ba. The third cathode protective layer 145b may be disposed on the third extended cathode electrode 143ba, and the third subpixel protective layer 151b may be disposed on the third extended cathode electrode 143ba.

The third extended organic light-emitting layer 142ba may be formed by extending the third organic light-emitting layer 142b of the third organic light-emitting element 140b from the emission region EAb of the third subpixel SPb to the non-emission region NEA-1 and NEA-2. The third extended cathode electrode 143ba may be formed by extending the third cathode electrode 143b of the third organic light-emitting element 140b from the emission region EAb of the third subpixel SPb to the non-emission region NEA-1 and NEA-2.

The third cathode protective layer 145b may be disposed on the third cathode electrode 143b in the emission region EAb of the plurality of third subpixels SPb, as illustrated in FIGS. 1, 2A, and 2B, and on the third extended cathode electrode 143ba in the non-emission region NEA-1 and NEA-2 of the third subpixel SPb along the second direction Y.

The third cathode protective layer 145b may be disposed on the third cathode electrode 143b of the third organic light-emitting element 140b and/or the third extended cathode electrode 143ba of the third connecting pattern 140ba.

The third cathode protective layer 145b may be called a capping layer, an element protective layer, an optical compensation layer, etc.

The third cathode protective layer 145b may physically, electrically and/or optically protect the third cathode electrode 143b and the third extended cathode electrode 143ba. For example, the third cathode protective layer 145b may prevent damage to the third cathode electrode 143b caused by static electricity in the PECVD equipment during the deposition process of the third subpixel protective layer 151b, which is a subsequent process. For example, the third cathode protective layer 145b can play an auxiliary role in allowing a third color light generated from the third organic light-emitting layer 142b to constructively interfere between the third anode electrode 141b and the third cathode electrode 143b. That is, the third cathode protective layer 145b may improve light emission efficiency by re-reflecting the third color light at an interface between the third cathode electrode 143b and the third cathode protective layer 145b having a high refractive index. In addition, the third cathode protective layer 145b may be composed of a multilayer film with another cathode protective film having a low refractive index, so that the optimal refractive index may be set so that more third color light may be extracted to the outside and light extraction can be maximized. In this instance, the third cathode protective layer 145b may be called a light extraction layer or an optical compensation layer.

The third subpixel protective layer 151b may be disposed on the third cathode protective layer 145b. As illustrated in FIG. 1, when the third organic light-emitting layer 142b or the third cathode electrode 143b is disposed in a stripe pattern along the second direction Y, the third subpixel protective layer 151b may also be disposed in a stripe pattern along the second direction Y.

The third subpixel protective layer 151b may comprise an organic material or an inorganic material or an insulating oxide film with an insulating property. The organic material may comprise polyimide, etc., the inorganic material may comprise SiO₂, SiON, SiNx, etc., and the insulating oxide film may comprise Al₂O₃, etc.

The third subpixel protective layer 151b may be at least one or more inorganic film. The third subpixel protective layer 151b may comprise a multilayer film comprising a capping layer.

For example, the third subpixel protective layer 151b may be composed of a double layer comprising a silicon-based or aluminum-based oxide layer and a silicon-based nitride layer. The nitride layer may be disposed on the oxide layer. For example, the oxide layer may be formed using an atomic layer deposition (ALD) process, and the nitride layer may be formed using a chemical vapor deposition (CVD) process. The ALD process has excellent step coverage, so that it completely covers particles that may occur in previous processes such as dry etching, ashing, and deposition, and may protect the third cathode electrode 143b from the environment together with the inorganic film formed consecutively afterwards. In the next process, i.e., the photo process, the developing solution may not penetrate into the third cathode electrode 143b and the third extended cathode electrode 143ba.

The shape of the third subpixel protective layer 151b may be the same as the shape of the third cathode protective layer 145b. The area of the third subpixel protective layer 151b may be the same as the area of the third cathode protective layer 145b.

The third subpixel protective layer 151b may physically, environmentally, electrically and/or optically protect the third cathode electrode 143b, the third extended cathode electrode 143ba, the third organic light-emitting layer 142b and/or the third extended organic light-emitting layer 142ba.

The third cathode protective layer 145b and the third subpixel protective layer 151b may be selectively employed alone.

Meanwhile, the power connecting structure 170 may be disposed on the power wirings 111 and 112, and the third cathode connecting structure 183 may be disposed on the third connecting pattern 140ba.

The power connecting structure 170 may be a structure for electrically connecting the bridge electrode 190 to the power wirings 111 and 112. The third cathode connecting structure 183 may be a structure for electrically connecting the bridge electrode 190 to the third connecting pattern 140ba. Specifically, the third cathode connecting structure 183 may be a structure for electrically connecting the bridge electrode 190 to the third extension cathode electrode 143ba of the third connecting pattern 140ba.

The power connecting structure 170 may comprise a power contact hole 171, and the third cathode connecting structure 183 may comprise a third cathode contact hole 188. The power contact hole 171 may be formed so that the power wirings 111 and 112 are exposed. The third cathode connecting structure 183 may be formed by penetrating the third cathode protective layer 145b and the third subpixel protective layer 151b so that the third extension cathode electrode 143ba is exposed.

The bridge electrode 190 may be disposed on the third subpixel protective layer 151b. The bridge electrode 190 may electrically connect the power connecting structure 170 and the third cathode connecting structure 183 on the third subpixel protective layer 151b. The bridge electrode 190 may be electrically connected to the power wirings 111 and 112 through the power contact hole 171. The bridge electrode 190 may be electrically connected to the third extended cathode electrode 143ba of the third connecting pattern 140ba through the third cathode contact hole 188.

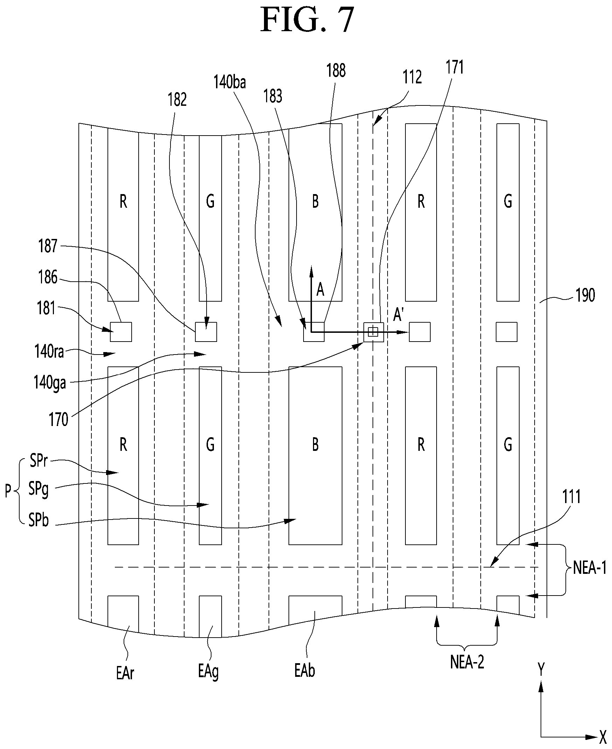

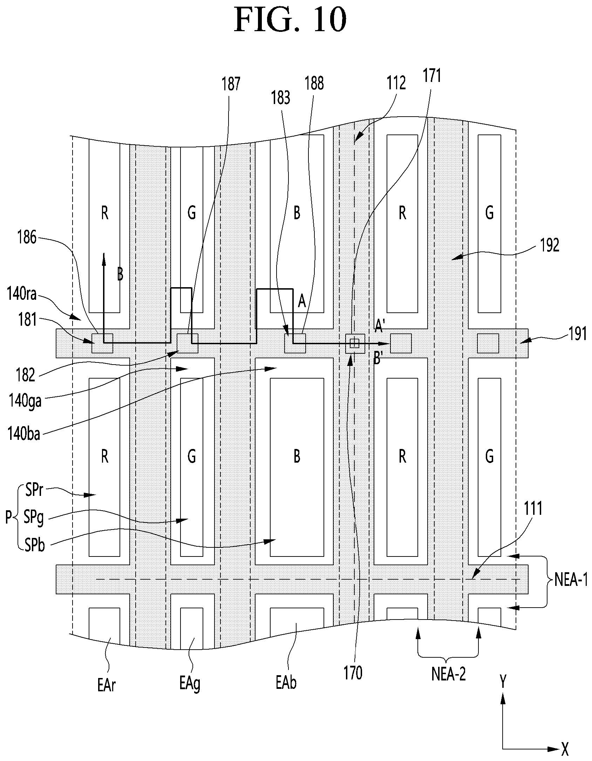

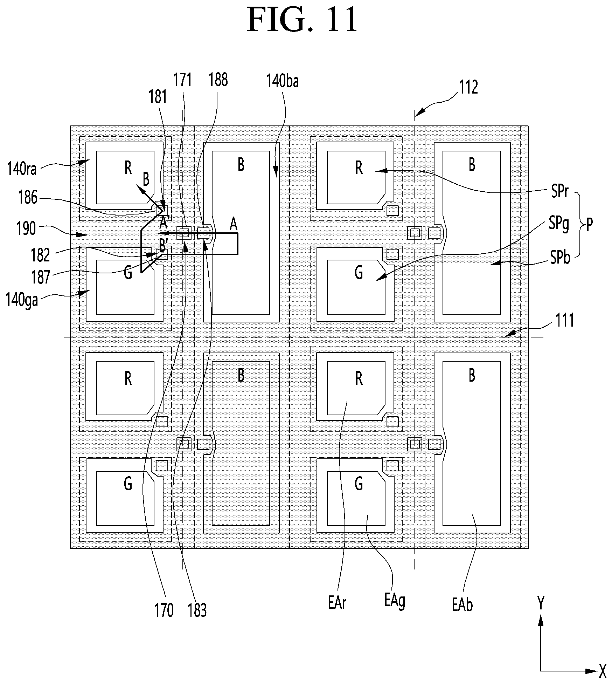

In addition, the bridge electrode 190 may be disposed only in the non-emission region NEA as in FIGS. 1 and 2, but when a transparent conductive film is used, it may be disposed on the entire display region as in FIG. 7, and may be disposed in a matrix form in the non-emission region NEA as in FIGS. 10 and 11.

Accordingly, a low voltage supplied to the power wirings 111 and 112 may be supplied to the third cathode electrode 143b of the third organic light-emitting element 140b through the power contact hole 171, the bridge electrode 190, the third cathode contact hole 188, and the third extended cathode electrode 143ba.

Meanwhile, an encapsulation layer 160 may be disposed on the substrate 100. The encapsulation layer 160 may be disposed on the emission region EAb of the third subpixel SPb as well as the non-emission region NEA-1 and NEA-2. The encapsulation layer 160 may be disposed on the third subpixel protective layer 151b in the emission region EAb of the third subpixel and the non-emission region NEA-1 and NEA-2, and may be disposed on the bridge electrode 190, the power connecting structure 170, and the third cathode connecting structure 183 in the non-emission region NEA-1 and NEA-2 of the third subpixel SPb.

Meanwhile, the bank protective layer 130 may be disposed on the bank 120. The bank protective layer 130 may comprise an inorganic film.

When the third subpixel protective layer 151b, the third cathode electrode 143b, the third organic light-emitting layer 142b, etc., are patterned using photo and etching, the bank 120 made of an organic material may also be etched.

However, since the bank protective layer 130 is disposed on the bank 120, even if the third subpixel protective layer 151b, the third cathode electrode 143b, the third organic light-emitting layer 142b, etc., are patterned, loss of the bank 120 can be prevented by the bank protective layer 130. When the bank 120 is made of an inorganic material, the bank protective layer 130 may be omitted.

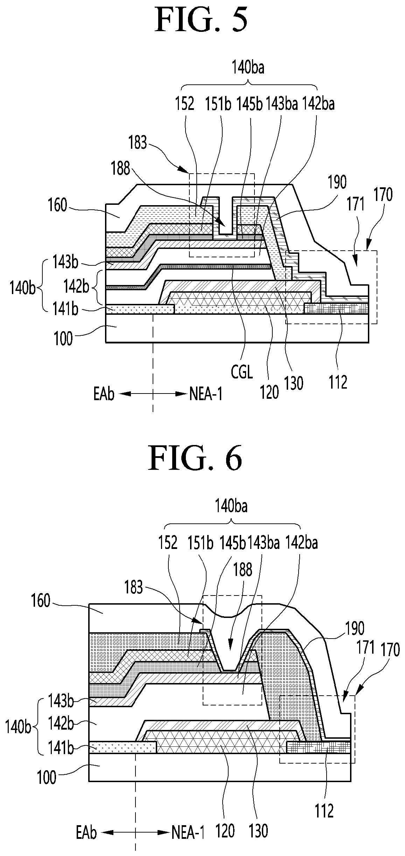

FIG. 5 is a cross-sectional view illustrating an organic light-emitting display device according to a fifth embodiment. FIG. 5 illustrates a connecting structure between the third subpixel SPb and the power wirings 111 and 112 along the A-A' lines of FIG. 1, FIG. 2A, and FIG. 2B, respectively. Although not illustrated, the connecting structure between the first subpixel SPr and the power wirings 111 and 112 and the connecting structure between the second subpixel SPg and the power wirings 111 and 112 may be the same as the connecting structure between the third subpixel SPb and the power wirings 111 and 112.

The fifth embodiment is the same as the fourth embodiment (FIG. 4) except for the pixel protective layer 152. In the fifth embodiment, components having the same shape, structure, and/or function as those of the fourth embodiment (FIG. 4) are given the same drawing reference numerals and detailed descriptions are omitted.

Referring to FIG. 5, the organic light-emitting display device according to the fifth embodiment may comprise a bank 120, a third organic light-emitting element 140b, a third connecting pattern 140ba, a power connecting structure 170, a third cathode connecting structure 183, a bridge electrode 190, etc.

The third connecting pattern 140ba may be disposed to extend from the emission region EAb of the third subpixel SPb on the bank 120 to the non-emission region NEA-1 and NEA-2.

The third connecting pattern 140ba may comprise a third extended organic light-emitting layer 142ba, a third extended cathode electrode 143ba, a third cathode protective layer 145b, a third subpixel protective layer 151b, and a pixel protective layer 152.

The third subpixel protective layer 151b may be disposed on the third cathode protective layer 145b. When the third cathode protective layer 145b is omitted, the third subpixel protective layer 151b may be in contact with an upper surface of the third cathode electrode 143b of the third organic light-emitting element 140b and an upper surface of the third extended cathode electrode 143ba of the third connecting pattern 140ba.

The third subpixel protective layer 151b may physically, environmentally, electrically and/or optically protect the third cathode electrode 143b, the third extended cathode electrode 143ba, the third organic light-emitting layer 142b and/or the third extended organic light-emitting layer 142ba.

For example, the third subpixel protective layer 151b may prevent the third cathode electrode 143b and the third extended cathode electrode 143ba from being oxidized when the substrate 100 is moved and exposed to the atmosphere for a subsequent process. For example, the third subpixel protective layer 151b may protect the third cathode electrode 143b and the third extended cathode electrode 143ba from foreign substances, etc., when the substrate 100 is moved and exposed to the atmosphere for a subsequent process. For example, the third subpixel protective layer 151b may prevent moisture, oxygen, etc., from penetrating into the third organic light-emitting layer 142b and the third extended organic light-emitting layer 142ba. For example, the third subpixel protective layer 151b may allow the third color light generated from the third organic light-emitting layer 142b to be extracted to the outside by constructive interference between the third anode electrode 141b and the third cathode electrode 143b. For example, the third subpixel protective layer 151b may be set to an optimal refractive index so as to maximize light extraction by considering the refractive index of the third organic light-emitting layer 142b and the refractive index of the atmosphere. In this instance, the third subpixel protective layer 151b may be called a light extraction layer or an optical compensation layer.

Meanwhile, the pixel protective layer 152 may be disposed in a plate shape on the substrate 100. The pixel protective layer 152 may be disposed in the display region of the substrate 100. The pixel protective layer 152 may be disposed on the emission regions EAr, EAg and EAb of the first subpixel SPr, the second subpixel SPg and the third subpixel SPb of each of the plurality of pixels P, and the non-emission region NEA-1 and NEA-2.

Referring again to FIG. 5, the pixel protective layer 152 may be disposed on an upper side of the third subpixel protective layer 151b as well as on a lateral part of the third connecting pattern 140ba. For example, the pixel protective layer 152 may be disposed on a lateral surface of the third extended organic light-emitting layer 142ba of the third connecting pattern 140ba.

The pixel protective layer 152 may prevent an electrical short between the low resistance layer of the third extended organic light-emitting layer 142ba of the third connecting pattern 140ba and the bridge electrode 190. The low resistance layer may comprise a charge generation layer CGL, a hole injection layer, etc., made of a low-resistance organic light-emitting material. The third extended organic light-emitting layer 142ba may be formed by extending the third organic light-emitting layer 142b of the third organic light-emitting element 140b from the emission region EAb of the third subpixel SPb to the non-emission region NEA-1 and NEA-2. When the third extended organic light-emitting layer 142ba is connected to the bridge electrode 190, an electrical short between the third extended organic light-emitting layer 142ba, i.e., the third organic light-emitting layer 142b, and the bridge electrode 190 may cause a color spot defect due to a leaked current that is connected to at least one or more organic light-emitting stack provided on the hole injection layer or the charge generation layer in the third organic light-emitting element 140b.

The lateral surface of the third extended organic light-emitting layer 142ba may be exposed together with the lateral surface of the third extended cathode electrode 143ba and the lateral surface of the third subpixel protective layer 151b by being patterned using the previous photo and etching. However, according to an embodiment, the pixel protective layer 152 may be disposed on the exposed lateral surface of the third extended organic light-emitting layer 142ba. Accordingly, even if the bridge electrode 190 is patterned and formed later using the photo and etching, an electrical short between the third connecting pattern 140ba and the bridge electrode 190 may not occur due to the pixel protective layer 152, so that a dark spot defect can be prevented.

The pixel protective layer 152 may comprise an organic material or an inorganic material, or an insulating oxide film with an insulating property. The organic material may comprise polyimide, etc., the inorganic material may comprise SiO₂, SiON, SiNx, etc., and the insulating oxide film may comprise Al₂O₃, etc.

One end of the pixel protective layer 152 is positioned on an upper surface of the bank 120 via a lateral part of the third connecting pattern 140ba, so that the electrical short between the low resistance layer of the third extended organic light-emitting layer 142ba and the bridge electrode 190 can be more completely blocked.

FIG. 6 is a cross-sectional view illustrating an organic light-emitting display device according to a sixth embodiment. FIG. 6 illustrates a connecting structure between the third subpixel SPb and the power wirings 111 and 112 along the A-A' line of FIG. 1, FIG. 2A, and FIG. 2B, respectively. Although not illustrated, the connecting structure between the first subpixel SPr and the power wirings 111 and 112 and the connecting structure between the second subpixel SPg and the power wirings 111 and 112 may be the same as the connecting structure between the third subpixel SPb and the power wirings 111 and 112.

The sixth embodiment is the same as the fifth embodiment (FIG. 5) except that the pixel protective layer 152 is formed of a transparent resin. Although not illustrated, in the step of depositing and patterning an inorganic insulating film like the sixth embodiment of FIG. 6, a photosensitive pattern made of a transparent resin may be developed and dry etched. In this instance, the pixel protective layer 152 may have a multilayer structure comprising a transparent resin and an inorganic film or a plurality of inorganic films under the transparent resin. In particular, this structure may prevent the organic component remaining during the resin curing process from penetrating into the lateral part of the third organic light-emitting layer 142b and reducing the lifespan of the third organic light-emitting element 140b.

In the sixth embodiment, components having the same shape, structure, and/or function as those of the fifth embodiment (FIG. 5) are given the same drawing reference numerals and detailed descriptions are omitted.

As illustrated in FIG. 6, the pixel protective layer 152 may comprise the third cathode protective layer 145b, the third subpixel protective layer 151b, and the pixel protective layer 152.

The pixel protective layer 152 may be disposed on the lateral part of the third connecting pattern 140ba as well as on the upper side of the third subpixel protective layer 151b. For example, the pixel protective layer 152 may be disposed on the lateral surface of the third extended organic light-emitting layer 142ba of the third connecting pattern 140ba.

The pixel protective layer 152 may be a planarization layer. That is, an upper surface of the pixel protective layer 152 has a flat surface, and when an undercut is formed at the lateral part of the third connecting pattern 140ba, the pixel protective layer 152 may form a gentle slope, so that the bridge electrode 190 formed by the subsequent process can be stably formed without being disconnected.

To this end, the pixel protective layer 152 may be formed of a transparent resin. Since the pixel protective layer 152 is formed of a transparent resin, not only does the upper surface of the pixel protective layer 152 have a flat surface, but also the third color light generated from the third organic light-emitting layer 142b thereunder can be stably emitted to the outside.

FIG. 7 is a plan view illustrating an organic light-emitting display device according to a seventh embodiment.

The seventh embodiment is the same as the first embodiment (FIG. 1) except that the bridge electrode 190 is formed as a flat plate to comprise a plurality of pixels P.

That is, the bridge electrode 190 may be disposed not only in the emission regions EAr, EAg, and EAb of the first subpixel SPr, the second subpixel SPg, and the third subpixel SPb of each of the plurality of pixels P, but also in the non-emission region NEA-1 and NEA-2. In this instance, the bridge electrode 190 may be made of a conductive material having excellent light transmittance so that the color light of each of the first subpixel SPr, the second subpixel SPg, and the third subpixel SPb in the top emission mode may be transmitted through the bridge electrode 190 and emitted to the outside.

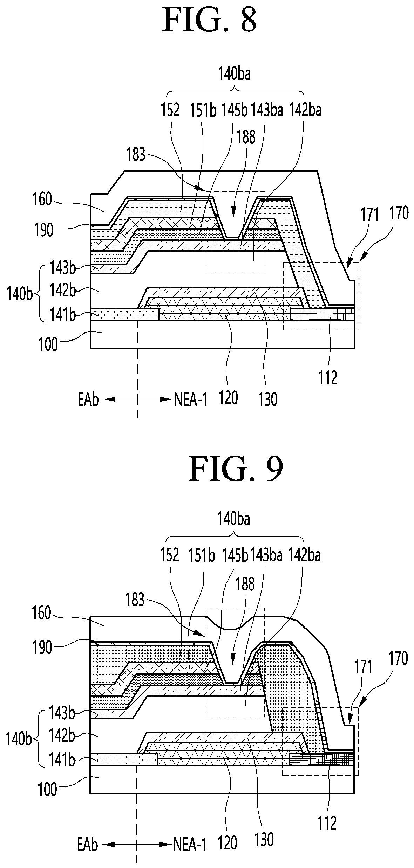

FIG. 8 is a cross-sectional view illustrating an organic light-emitting display device according to an eighth embodiment. FIG. 8 illustrates a connecting structure between the third subpixel SPb and the power wirings 111 and 112 along the line A-A' of FIG. 7. Although not illustrated, the connecting structure between the first subpixel SPr and the power wirings 111 and 112 and the connecting structure between the second subpixel SPg and the power wirings 111 and 112 may be identical to the connecting structure between the third subpixel SPb and the power wirings 111 and 112.

The eighth embodiment may be the same as the fifth embodiment (FIG. 5) except that the bridge electrode 190 is disposed in the emission region EAb of the third subpixel SPb as well as the non-emission region NEA-1 and NEA-2. In the eighth embodiment, components having the same shape, structure, and/or function as those in the fifth embodiment (FIG. 5) are given the same drawing reference numerals and detailed descriptions are omitted.

As illustrated in FIG. 8, the third organic light-emitting element 140b may be disposed in the emission region EAb of the third subpixel SPb, and the third connecting pattern 140ba may be disposed in the non-emission region NEA-1 and NEA-2 of the third subpixel SPb.

The third connecting pattern 140ba may be disposed to extend from the emission region EAb of the third subpixel SPb to the non-emission region NEA-1 and NEA-2 on the bank 120.

The third connecting pattern 140ba may comprise a third extended organic light-emitting layer 142ba, a third extended cathode electrode 143ba, and a pixel protective layer 152.

The pixel protective layer 152 may comprise a third cathode protective layer 145b, a third subpixel protective layer 151b, and a pixel protective layer 152. The pixel protective layer 152 may be disposed on the emission region EAb of the third subpixel SPb as well as the non-emission region NEA-1 and NEA-2. The pixel protective layer 152 may be disposed on the upper side of the third subpixel protective layer 151b as well as on the lateral part of the third connecting pattern 140ba, so that a short circuit between the low resistance layer included in the third organic light-emitting layer 142b of the third organic light-emitting element 140b and the bridge electrode 190 can be prevented.

The bridge electrode 190 may be disposed on the pixel protective layer 152. The bridge electrode 190 may be disposed on at least a display region of the substrate 100. As illustrated in FIG. 7, the display region may comprise a plurality of pixels P, each of which comprises a first subpixel SPr, a second subpixel SPg, and a third subpixel SPb.

As illustrated in FIG. 8, the bridge electrode 190 may be disposed in the emission region EAb of the third subpixel SPb as well as the non-emission region NEA-1 and NEA-2. The bridge electrode 190 may be connected to the power wirings 111 and 112 from the emission region EAb of the third subpixel SPb via the non-emission region NEA-1 and NEA-2. At this time, a part of the bridge electrode 190 may be electrically connected to the third extended cathode electrode 143ba of the third connecting pattern 140ba through the third cathode contact hole 188 of the third cathode connecting structure 183.

As illustrated in FIG. 7, the bridge electrode 190 may be disposed as a flat surface in the display region, and a plurality of regions of the bridge electrode 190 may be electrically connected to a first subpixel SPr, a second subpixel SPg, and a third subpixel SPb of a pixel.

According to the embodiment, since the bridge electrode 190 is formed as a flat surface, photo and etching are not required to form a separate pattern, so that the process time and process cost can be shortened. A transparent conductive film such as IZO, ITO, etc., may be deposited only in the display region during deposition using a sputtering equipment, and a deposition may be performed by welding a metal mask opened in cell units to a tray and covering the substrate. Such a mask is called a cell mask.

Meanwhile, since the bridge electrode 190 is disposed on the emission region EAb of the third subpixel SPb, it may be made of a conductive material with excellent light transmittance. The conductive material may comprise, for example, ITO, IZO, etc. Accordingly, the third color light generated from the third subpixel SPb may be transmitted through the bridge electrode 190 and emitted to the outside.

FIG. 9 is a cross-sectional view illustrating an organic light-emitting display device according to a ninth embodiment. FIG. 9 illustrates a connecting structure between the third subpixel SPb and the power wirings 111 and 112 along the line A-A' of FIG. 7. Although not illustrated, the connecting structure between the first subpixel SPr and the power wirings 111 and 112 and the connecting structure between the second subpixel SPg and the power wirings 111 and 112 may be the same as the connecting structure between the third subpixel SPb and the power wirings 111 and 112.

The ninth embodiment may be the same as the sixth embodiment (FIG. 6) except that the bridge electrode 190 is disposed in the emission region EAb of the third subpixel SPb as well as the non-emission region NEA-1 and NEA-2. In the ninth embodiment, components having the same shape, structure, and/or function as those of the sixth embodiment (FIG. 6) are given the same drawing reference numerals and detailed descriptions are omitted.

As illustrated in FIG. 9, the third organic light-emitting element 140b may be disposed in the emission region EAb of the third subpixel SPb, and the third connecting pattern 140ba may be disposed in the non-emission region NEA-1 and NEA-2 of the third subpixel SPb.

The third connecting pattern 140ba may be disposed to extend from the emission region EAb of the third subpixel SPb to the non-emission region NEA-1 and NEA-2 on the bank 120.

The third connecting pattern 140ba may comprise a third extended organic light-emitting layer 142ba, a third extended cathode electrode 143ba, and a pixel protective layer 152.

The pixel protective layer 152 may comprise a third cathode protective layer 145b, a third subpixel protective layer 151b, and a pixel protective layer 152. The pixel protective layer 152 may be disposed in the emission region EAb of the third subpixel SPb as well as the non-emission region NEA-1 and NEA-2. The pixel protective layer 152 may be disposed on the lateral part of the third connecting pattern 140ba as well as the upper side of the third subpixel protective layer 151b, so that a short circuit between the low resistance layer included in the third organic light-emitting layer 142b of the third organic light-emitting element 140b and the bridge electrode 190 can be prevented.

In addition, the pixel protective layer 152 may be formed of a transparent resin. As described above in the sixth embodiment, the pixel protective layer 152 formed of a transparent resin may be provided with a double-layer structure comprising an inorganic film or a multilayer structure. Since the pixel protective layer 152 is formed of a transparent resin, not only does the upper surface of the pixel protective layer 152 have a flat surface, but also the third color light generated in the third organic light-emitting layer 142b thereunder can be stably emitted to the outside.

Meanwhile, the bridge electrode 190 may be disposed on the pixel protective layer 152. The arrangement structure of the bridge electrode 190 is the same as the arrangement structure of the bridge electrode 190 illustrated in FIG. 8, and therefore, detailed descriptions thereof will be omitted.

According to the embodiment, since the bridge electrode 190 is formed as a flat plate, photo and etching are not required to form a separate pattern, and thus, the process time and process cost can be shortened.

FIG. 10 is a plan view illustrating an organic light-emitting display device according to a tenth embodiment.

The tenth embodiment is the same as the first embodiment (FIG. 1) except that the protective films 151b and 152 of the emission region are removed by using the bridge electrodes 191 and 192, and the bridge electrodes 191 and 192 are in the form of bars intersecting each other. In the fourth embodiment, components having the same shape, structure, and/or function as those of the first embodiment (FIG. 1) are given the same drawing reference numerals and detailed descriptions thereof will be omitted.

As illustrated in FIG. 10, a plurality of first bridge electrodes 191 and a plurality of second bridge electrodes 192 may be disposed in bar shapes that are electrically connected to each other by crossing each other.

A plurality of first bridge electrodes 191 may be disposed long along a first direction X, and a plurality of second bridge electrodes 192 may be disposed long along a second direction Y.

A power connecting structure 170 may be disposed in an intersection region of the first bridge electrode 191 and the second bridge electrode 192. A first cathode connecting structure 181, a second cathode connecting structure 182, and a third cathode connecting structure 183 may be disposed to vertically overlap with the first bridge electrode 191 disposed in the first direction X.

The first bridge electrode 191 may be disposed across the first cathode connecting structure 181, the second cathode connecting structure 182, and the third cathode connection structure 183 along the first direction X. The second bridge electrode 192 may be connected to the first bridge electrode 191 and may be disposed long along the second direction Y.

The power wirings 111 and 112 may be electrically connected to the first bridge electrode 191 (or the second bridge electrode 192) through the power contact hole 171 of the power connecting structure 170. The first bridge electrode 191 may be commonly connected to a first cathode contact hole 186 of the first cathode connecting structure 181, a second cathode contact hole 187 of the second cathode connecting structure 182, and a third cathode contact hole 188 of the third cathode connecting structure 183. Accordingly, the power wirings 111 and 112 with the low voltage may be electrically connected to a first connecting pattern 140ra through the first bridge electrode 191 and the first cathode contact hole 186 of the first cathode connecting structure 181.

The power wirings 111 and 112 with the low voltage may be electrically connected to a second connecting pattern 140ga through the first bridge electrode 191 and the second cathode contact hole 187 of the second cathode connecting structure 182. The power wirings 111 and 112 with the low voltage may be electrically connected to a third connecting pattern 140ba through the first bridge electrode 191 and the third cathode contact hole 188 of the third cathode connecting structure 183. As a result, the power wirings 111 and 112 with the low voltage may be commonly connected to the first subpixel SPr, the second subpixel SPg, and the third subpixel SPb through the first bridge electrode 191.

FIG. 11 is a plan view illustrating an organic light-emitting display device according to an eleventh embodiment.

The eleventh embodiment is the same as the second embodiment (FIGS. 2A and 2B) except that the bridge electrode 190 is disposed in the non-emission region NEA-1 and NEA-2 of the first subpixel SPr to the third subpixel SPb in a structure in which a dot shape and a stripe shape are mixed.

As illustrated in FIG. 11, the plurality of pixels P may each comprise the first subpixel SPr, the second subpixel SPg, and the third subpixel SPb.

The first subpixel SPr to the third subpixel SPb may have a structure in which the dot shape and the stripe shape are mixed. The first subpixel SPr to the third subpixel SPb may each comprise an emission region EAr, EAg, and EAb, and a non-emission region NEA-1 and NEA-2. The first subpixel SPr and the second subpixel SPg may be disposed in a dot shape, respectively. The plurality of third subpixels SPb may have a stripe pattern (or stripe shape) that has the same color and is disposed long along the second direction Y.

In an embodiment, the bridge electrode 190 may be disposed in the non-emission region NEA-1 and NEA-2 of the first subpixel SPr to the third subpixel SPb. The bridge electrode 190 may be disposed in the non-emission region NEA-1 and NEA-2 surrounding the emission region EAr of the first subpixel SPr. The bridge electrode 190 may be disposed in the non-emission region NEA-1 and NEA-2 surrounding the emission region EAg of the second subpixel SPg. The bridge electrode 190 may be disposed in the non-emission region NEA-1 and NEA-2 positioned on both sides of the emission region EAb of the third subpixel SPb.

The power connecting structure 170, the first cathode connecting structure 181, the second cathode connecting structure 182, and the third cathode connecting structure 183 are identical to the corresponding structures illustrated in FIGS. 2A and 2B, and therefore, detailed descriptions thereof will be omitted.

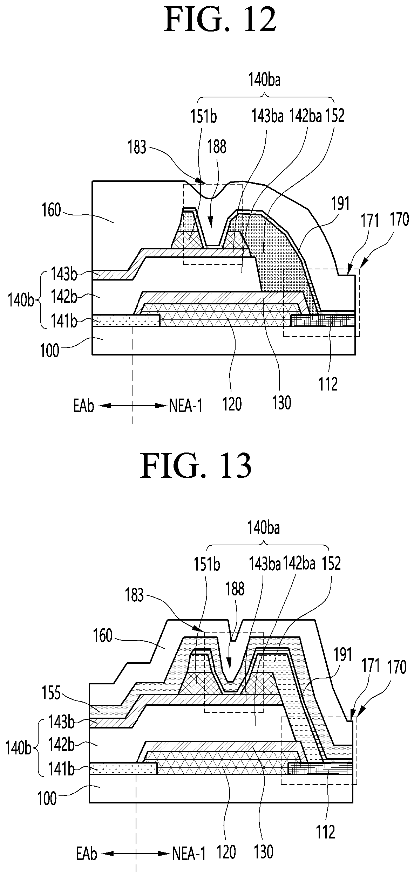

FIG. 12 is a cross-sectional view illustrating an organic light-emitting display device according to a twelfth embodiment. FIG. 12 illustrates a connecting structure between the third subpixel SPb and the power wirings 111 and 112 along the A-A' lines of FIGS. 10 and 11, respectively. Although not illustrated, the connecting structure between the first subpixel SPr and the power wirings 111 and 112 and the connecting structure between the second subpixel SPg and the power wirings 111 and 112 may be the same as the connecting structure between the third subpixel SPb and the power wirings 111 and 112.

The twelfth embodiment may be the same as the 6th embodiment (FIG. 6) except that the pixel protective layer 152 and the third subpixel protective layer 151b are disposed only in the non-emission region NEA-1 and NEA-2 of the third subpixel SPb. In the twelfth embodiment, components having the same shape, structure, and/or function as those of the 6th embodiment (FIG. 6) are given the same drawing reference numerals and detailed descriptions are omitted.

Referring to FIG. 12, the organic light-emitting display device according to the twelfth embodiment may comprise a bank 120, a third organic light-emitting element 140b, a third connecting pattern 140ba, a power connecting structure 170, a third cathode connecting structure 183, a bridge electrode 190, etc.

The third connecting pattern 140ba may comprise a third extended organic light-emitting layer 142ba, a third extended cathode electrode 143ba, a third subpixel protective layer 151b, and a pixel protective layer 152. Although not illustrated, a third cathode protective layer may be disposed between the third extended cathode electrode 143ba and the third subpixel protective layer 151b.

The third extended organic light-emitting layer 142ba may be formed by extending the third organic light-emitting layer 142b of the third organic light-emitting element 140b from the emission region EAb of the third subpixel SPb to the non-emission region NEA-1 and NEA-2. The third extended cathode electrode 143ba may be formed by extending the third cathode electrode 143b of the third organic light-emitting element 140b from the emission region EAb of the third subpixel SPb to the non-emission region NEA-1 and NEA-2.

In an embodiment, the third subpixel protective layer 151b and the pixel protective layer 152 may be disposed only in the non-emission region NEA-1 and NEA-2 of the third subpixel SPb. The third subpixel protective layer 151b and the pixel protective layer 152 may be vertically overlapped with the bank 120, respectively. The third subpixel protective layer 151b and the pixel protective layer 152 may not be vertically overlapped with the third anode electrode 141b of the third organic light-emitting element 140b. The third subpixel protective layer 151b and the pixel protective layer 152 may be formed by patterning using photo and etching.

The pixel protective layer 152 is disposed at least on the upper surface of the third extended cathode electrode 143ba, thereby preventing an electrical short between the bridge electrode 190 and the third extended cathode electrode 143ba.

In addition, the pixel protective layer 152 may be formed of a transparent resin, but is not limited thereto.

The bridge electrode 190 may be disposed on the pixel protective layer 152. The bridge electrode 190 may be connected to the power wirings 111 and 112 through the power connecting structure 170, and may be electrically connected to the third extended cathode electrode 143ba of the third connecting pattern 140ba through the third cathode connecting structure 183.

The encapsulation layer 160 may be disposed in the emission region EAb of the third subpixel SPb, and the non-emission region NEA-1 and NEA-2. The encapsulation layer 160 may be in contact with the upper surface of the third cathode electrode 143b of the third organic light-emitting element 140b in the emission region EAb of the third subpixel SPb.

Meanwhile, as illustrated in FIG. 12, when the third subpixel protective layer 151b and the pixel protective layer 152 are patterned and formed, the upper surface of the third cathode electrode 143b of the third organic light-emitting element 140b and the upper surface of the third extended cathode electrode 143ba of the third connecting pattern 140ba may be exposed. Thereafter, when exposed to the atmosphere for a post-process, the exposed third cathode electrode 143b and the exposed third extended cathode electrode 143ba may be oxidized, so that the functions as electrodes may be lost, resulting in dark spot defects such as poor lighting.

A structure for solving the above-described problem is described in detail with reference to FIG. 13.

FIG. 13 is a cross-sectional view illustrating a third subpixel of an organic light-emitting display device according to a thirteenth embodiment. FIG. 13 illustrates a connecting structure between the third subpixel SPb and the power wirings 111 and 112 along the A-A' lines of FIGS. 10 and 11, respectively. Although not illustrated, the connecting structure between the first subpixel SPr and the power wirings 111 and 112 and the connecting structure between the second subpixel SPg and the power wirings 111 and 112 may be the same as the connecting structure between the third subpixel SPb and the power wirings 111 and 112.

The thirteenth embodiment is similar to the twelfth embodiment (FIG. 12) except that the cathode protective layer 155 is disposed on the emission region EAb of the third subpixel SPb as well as on the bridge electrode 190. In the thirteenth embodiment, components having the same shape, structure, and/or function as those in the twelfth embodiment (FIG. 12) are given the same drawing reference numerals and detailed descriptions are omitted.

As illustrated in FIG. 13, the third connecting pattern 140ba may comprise a third subpixel protective layer 151b, a pixel protective layer 152, and a cathode protective layer 155.

The third subpixel protective layer 151b and the pixel protective layer 152 may be formed only in the non-emission region NEA-1 and NEA-2 of the third subpixel SPb. That is, the third subpixel protective layer 151b and the pixel protective layer 152 may be formed by patterning using photo and etching. Accordingly, the upper surface of the third cathode electrode 143b of the third organic light-emitting element 140b and the upper surface of the third extended cathode electrode 143ba of the third connecting pattern 140ba may be exposed.

The cathode protective layer 155 may be disposed on the third cathode electrode 143b of the third organic light-emitting element 140b in the emission region EAb of the third subpixel SPb, as well as the non-emitting regions NEA-1 and NEA-2.

The cathode protective layer 155 may be disposed on the third cathode electrode 143ba of the third organic light-emitting element 140b in the emission region EAb of the third subpixel SPb, and on the third extended cathode electrode 143ba of the third connecting pattern 140ba in the non-emitting regions NEA-1 and NEA-2 of the third subpixel SPb. Accordingly, since the cathode protective layer 155 is disposed on the upper surface of the exposed third cathode electrode 143b and the upper surface of the third extended cathode electrode 143ba, damage to the cathode caused by static electricity in the PECVD equipment can be prevented during the next process of forming an encapsulation layer. In addition, the cathode protective layer 155 may play an auxiliary role of constructive interference between the third anode electrode 141b and the third cathode electrode 143b. That is, the third color light generated in the third organic light-emitting layer 142b may be reflected again at an interface between the third cathode electrode 143b and the cathode protective layer 155 having a high refractive index, thereby improving the light emission efficiency. In addition, since the cathode protective layer 155 is composed of a multilayer film with an additional cathode protective film having a low refractive index and is set to an optimal refractive index so that light extraction is maximized, more third color light can be extracted to the outside. In this instance, the cathode protective layer 155 may be called a light extraction layer or an optical compensation layer.

Meanwhile, the cathode protective layer 155 may be disposed on the bridge electrode 190 in the non-emission region NEA-1 and NEA-2 of the third subpixel SPb. The bridge electrode 190 may be physically and/or environmentally protected by the cathode protective layer 155.

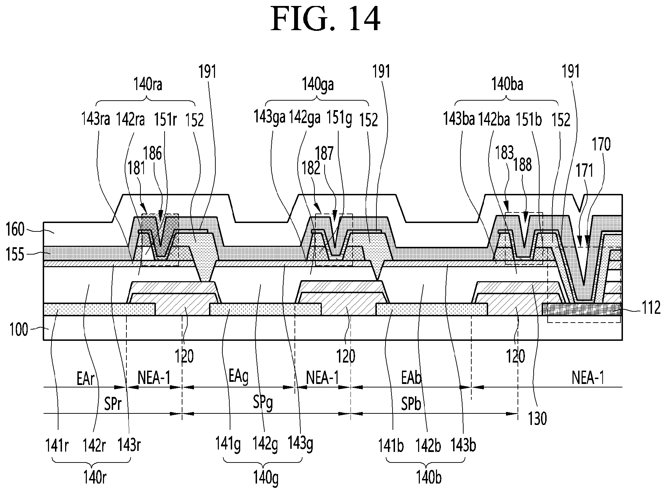

FIG. 14 is a cross-sectional view illustrating one pixel of an organic light-emitting display device according to a fourteenth embodiment. FIG. 14 illustrates a connecting structure between the first subpixel SPr to the third subpixel SPb and the power wirings 111 and 112 along the line B-B' of FIG. 10. The structure illustrated in FIG. 14 may be equally applied to FIG. 11.

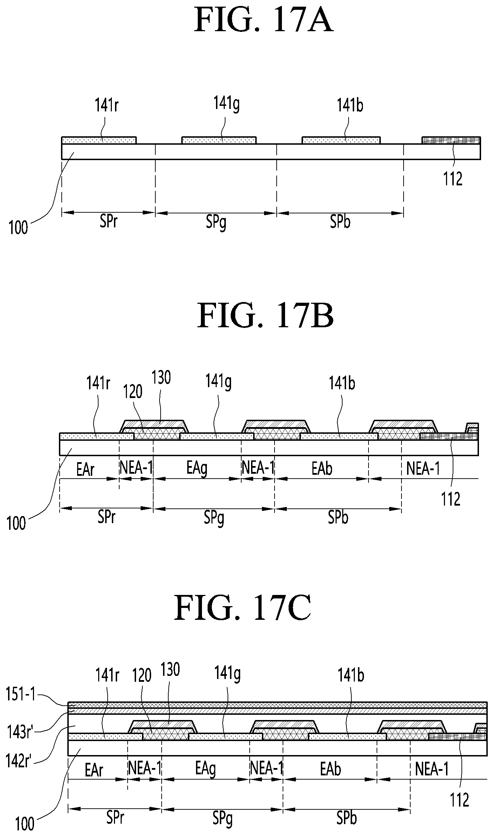

In the first to seventh embodiments, the content that may be insufficient as described above with respect to the subpixel is expanded to the pixel as in FIG. 14 (the seventh embodiment), thereby expanding the explanation to the pixel perspective. In addition, the cross-sectional view (FIGS. 17A to 17I) of FIG. 14 (the seventh embodiment) is expanded to the pixel to explain the process step by step. The seventh embodiment is a structure that requires the most process steps, and the process for the first to sixth embodiments with shortened process steps may be explained together.

In the thirteenth embodiment (FIG. 13), it may be confirmed that the connecting structure between the third subpixel SPb and the power wirings 111 and 112, as well as the connecting structure between the first subpixel SPr and the power wirings 111 and 112, and the connecting structure between the second subpixel SPg and the power wirings 111 and 112 are expanded in the pixel P.

Referring to FIGS. 10 and 14, the organic light-emitting display device according to the fourteenth embodiment may comprise a bank 120, a first organic light-emitting element 140r to third organic light-emitting element 140b, a first connecting pattern 140ra to a third connecting pattern 140ba, a power connecting structure 170, a first cathode connecting structure 181 to a third cathode connecting structure 183, a bridge electrode 190, a cathode protective layer 155, an encapsulation layer 160, etc.

The first organic light-emitting element 140r may be disposed in the first subpixel SPr, the second organic light-emitting element 140g may be disposed in the second subpixel SPg, and the third organic light-emitting element 140b may be disposed in the third subpixel SPb.

The first organic light-emitting element 140r to the third organic light-emitting element 140b may each comprise an anode electrode, an organic light-emitting layer, and a cathode electrode.

The first connecting pattern 140ra, the second connecting pattern 140ga, and the third connecting pattern 140ba may be disposed to extend from the emission region EAr, EAg, and EAb to the non-emission region NEA-1 and NEA-2, respectively.

The first connecting pattern 140ra may comprise a first extended organic light-emitting layer 142ra, a first extended cathode electrode 143ra, a first subpixel protective layer 151r, and a pixel protective layer 152. The first extended organic light-emitting layer 142ra may be formed by extending a first organic light-emitting layer 142r of the first organic light-emitting element 140r from the emission region EAr of the first subpixel SPr to the non-emission region NEA-1 and NEA-2. The first extended cathode electrode 143ra may be formed by extending a first cathode electrode 143r of the first organic light-emitting element 140r from the emission region EAr of the first subpixel SPr to the non-emission region NEA-1 and NEA-2.

The second connecting pattern 140ga may comprise a second extended organic light-emitting layer 142ga, a second extended cathode electrode 143ga, a second subpixel protective layer 151g, and a pixel protective layer 152. The second extended organic light-emitting layer 142ga may be formed by extending a second organic light-emitting layer 142g of the second organic light-emitting element 140g from the emission region EAg of the second subpixel SPg to the non-emission region NEA-1 and NEA-2. The second extended cathode electrode 143ga may be formed by extending a second cathode electrode 143g of the second organic light-emitting element 140g from the emission region EAg of the second subpixel SPg to the non-emission region NEA-1 and NEA-2.

The third connecting pattern 140ba may comprise a third extended organic light-emitting layer 142ba, a third extended cathode electrode 143ba, a third subpixel protective layer 151b, and a pixel protective layer 152. The third extended organic light-emitting layer 142ba may be formed by extending a second organic light-emitting layer 142g of the third organic light-emitting element 140b from the emission region EAb of the third subpixel SPb to the non-emission region NEA-1 and NEA-2. The third extended cathode electrode 143ba may be formed by extending a third cathode electrode 143b of the third organic light-emitting element 140b from the emission region EAb of the third subpixel SPb to the non-emission region NEA-1 and NEA-2.

The first subpixel protective layer 151r and the pixel protective layer 152 may be disposed in the non-emission region NEA-1 and NEA-2 of the first subpixel SPr, the second subpixel protective layer 151g and the pixel protective layer 152 may be disposed in the non-emission region NEA-1 and NEA-2 of the second subpixel SPg, and the third subpixel protective layer 151b and the pixel protective layer 152 may be disposed in the non-emission region NEA-1 and NEA-2 of the third subpixel SPb.

The first subpixel protective layer 151r to the third subpixel protective layer 151b may be individually disposed in the first subpixel SPr to the third subpixel SPb. The pixel protective layers 152 of the first subpixel SPr to the third subpixel SPb may be connected to each other continuously in the non-emitting regions NEA-1 and NEA-2 of the subpixels adjacent to each other, but are not limited thereto.

The pixel protective layer 152 may be disposed on at least a lateral surface of the first extended cathode electrode 143ra of the first connecting pattern 140ra, a lateral surface of at least the second extended cathode electrode 143ga of the second connecting pattern 140ga, and a lateral surface of at least the third extended cathode electrode 143ba of the third connecting pattern 140ba. The pixel protective layer 152 may be disposed on at least a lateral surface of the first extended cathode electrode 143ra of the first connecting pattern 140ra and a lateral surface of at least the third extended cathode electrode 143ba of the third connecting pattern 140ba in the power contact hole 171 of the power connecting structure 170.

The first subpixel protective layer 151r to the third subpixel protective layer 151b may physically, electrically and/or optically protect the first cathode electrode 143r to the third cathode electrode 143b, the first extended cathode electrode 143ra to the third extended cathode electrode 143ba, the first organic light-emitting layer 142r to the third organic light-emitting layer 142b and/or the first extended organic light-emitting layer 142ra to the third extended organic light-emitting layer 142ba.

For example, the first subpixel protective layer 151r to the third subpixel protective layer 151b may prevent the first cathode electrode 143r to the third cathode electrode 143b and the first extended cathode electrode 143ra to the third extended cathode electrode 143ba from being oxidized when the substrate 100 is moved and exposed to the atmosphere for a subsequent process. For example, the first subpixel protective layer 151r to the third subpixel protective layer 151b may prevent the organic light-emitting elements 140r, 140b, and 140g from becoming dark spots due to penetration of a developer solution in a photolithography process.

For example, the first subpixel protective layer 151r to the third subpixel protective layer 151b may further amplify the light generated from the organic light-emitting layers 142r, 142g, and 142b by reflecting the amplified light through constructive interference between the anode electrodes 141r, 141g, and 141b and the cathode electrodes 143r, 143g, and 143b, or may allow the color light to be well extracted to the outside. For example, the first subpixel protective layer 151r to the third subpixel protective layer 151b may have an optimal refractive index set in consideration of the refractive indices of the first organic light-emitting layer 142r to the third organic light-emitting layer 142b and the refractive index of the atmosphere, respectively, so as to maximize light extraction. Accordingly, a multilayer film for each function may be provided in order to satisfy these functions. For example, the multilayer film may be an inorganic capping layer on an upper part of an organic capping layer, a silicon oxide film formed by ALD on an upper part of the inorganic capping layer, and a silicon nitride film formed by PECVD on an upper part of the silicon oxide film. Accordingly, the subpixel protective layers 151r, 151g, and 151b have the functions of a light extraction layer, an optical compensation layer, and an encapsulation layer.

The cathode protective layer 155 may be disposed in the emission regions EAr, EAg, and EAb of the first to third subpixels SPr to SPb, as well as in the non-emission region NEA-1 and NEA-2.

The cathode protective layer 155 may be disposed on the cathode electrodes 143r, 143g and 143b of the organic light-emitting elements 140r, 140b and 140g in the emission regions EAr, EAg and EAb of the subpixels SPr, SPg and SPb, and on the extended cathode electrodes 143ra, 143ga and 143ba of the connecting patterns 140ra, 140ga and 140ba in the non-emission region NEA-1 and NEA-2 of the subpixels SPr, SPg and SPb. In addition, the cathode protective layer 155 may be disposed on the bridge electrode 190 in the non-emission region NEA-1 and NEA-2 of the subpixels SPr, SPg and SPb.

Accordingly, the light extraction efficiency can be improved by the cathode protective layer 155, and the static electricity-induced dark spot defect that may occur during the deposition of the encapsulation layer 160 by the next process, PECVD, can be prevented.

In addition, while maintaining a vacuum in a state where the cathode electrodes 143r, 143g, and 143b are exposed, a reverse voltage may be applied to the organic light-emitting elements 140r, 140g, and 140b in an atmosphere containing a small amount of oxygen or moisture.

In the subpixels where the organic light-emitting elements 140r, 140g, and 140b have electrical leakage or are short-circuited and have become dark spots, the cathode electrode 143r, 143g, and 143b is partially oxidized or removed by the overcurrent.

Through this process, the dark-spot subpixel is repaired back to a normal subpixel. The yield can be improved by drastically reducing the number of dark spots per panel (from 100 to 3), which is a key specification of a good panel.

Meanwhile, the cathode electrodes 143r, 143g and 143b are made of silver (Ag), zinc (Zn), aluminum (Al) and indium (In) or an alloy thereof, and the electron injection layer of the organic light-emitting layer may comprise a material comprising at least one selected from ytterbium (Yb), yttrium (Y), lithium (Li), sodium (Na), potassium (K), rubidium (Rb), cesium (Cs), calcium (Ca), strontium (Sr), barium (Ba), radium (Ra), scandium (Sc), lanthanum (La), cerium (Ce), ruthenium (Ru) and samarium (Sm) having a work function of 4.0 eV or less.

In the process of dry etching the pixel protective layer 152 and the subpixel protective layer 151r, 151g and 151b formed on the upper parts of the cathode electrodes 143r, 143g and 143b of the emission regions EAr, EAg and EAb, the cathode electrodes 143r, 143g and 143b can be easily removed by a gas plasma such as CF₄ due to minimal oxidation and the oxide film generated by the oxidation can be easily removed by another gas plasma, thereby minimizing the contact resistance with the bridge electrodes 190, 191 and 192.

The first cathode connecting structure 181 to the third cathode connecting structure 183 may comprise a first cathode contact hole 186 to a third cathode contact hole 188, respectively.

The bridge electrode 190 may be disposed on the pixel protective layer 152 in the non-emission region NEA-1 and NEA-2 of the first subpixel SPr, the pixel protective layer 152 in the non-emission region NEA-1 and NEA-2 of the second subpixel SPg, and the pixel protective layer 152 in the non-emission region NEA-1 and NEA-2 of the third subpixel SPb.

The bridge electrode 190 may be electrically connected to the power wirings 111 and 112 through the power contact hole 171 of the power connecting structure 170.

The bridge electrode 190 may be electrically connected to the first extended cathode electrode 143ra of the first connecting pattern 140ra through the first cathode contact hole 186 of the first cathode connecting structure 181 in the non-emission region NEA-1 and NEA-2 of the first subpixel SPr. The bridge electrode 190 may be electrically connected to the second extended cathode electrode 143ga of the second connecting pattern 140ga through the second cathode contact hole 187 of the second cathode connecting structure 182 in the non-emission region NEA-1 and NEA-2 of the second subpixel SPg. The bridge electrode 190 may be electrically connected to the third extended cathode electrode 143ba of the third connecting pattern 140ba through the third cathode contact hole 188 of the third cathode connecting structure 183 in the non-emission region NEA-1 and NEA-2 of the third subpixel SPb.

According to an embodiment, before the photo and etching processes are performed, the first subpixel protective layer 151r to the third subpixel protective layer 151b may be disposed on the first cathode electrode 143r to the third cathode electrode 143b so that the first cathode electrode 143r to the third cathode electrode 143b are not exposed. Before the photo and etching processes are performed, a pixel protective layer 152 may be disposed on the lateral surfaces of the first extended cathode electrode 143ra to the third extended cathode electrode 143ba of the first connecting pattern 140ra to the third connecting pattern 140ba so that the lateral surfaces of the first extended cathode electrode 143ra to the third extended cathode electrode 143ba are not exposed. Accordingly, the first cathode to the third cathode electrode 143b may be physically, electrically, and/or optically protected by the first subpixel protective layer 151r to the third subpixel protective layer 151b. In addition, an electrical short between the first organic light-emitting element 140r to the third organic light-emitting element 140b and the bridge electrode 190 can be prevented by the pixel protective layer 152.

### [Manufacturing method and manufacturing system]

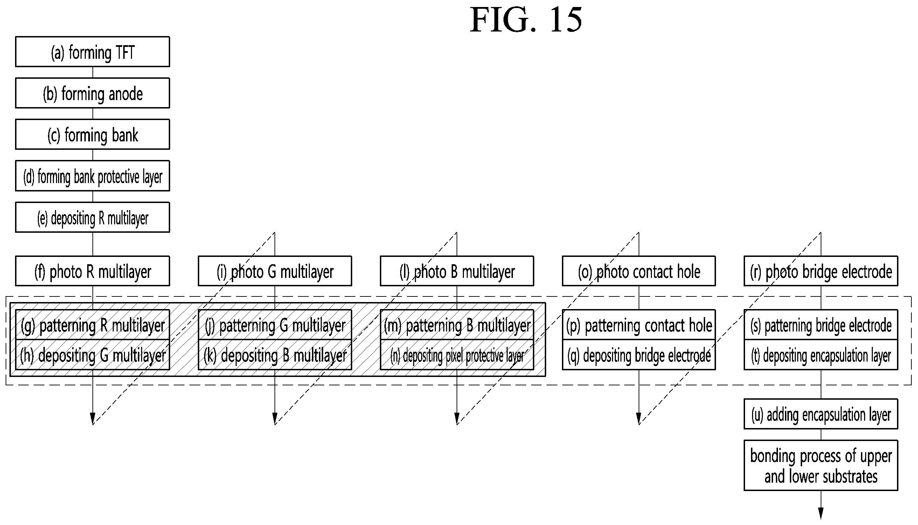

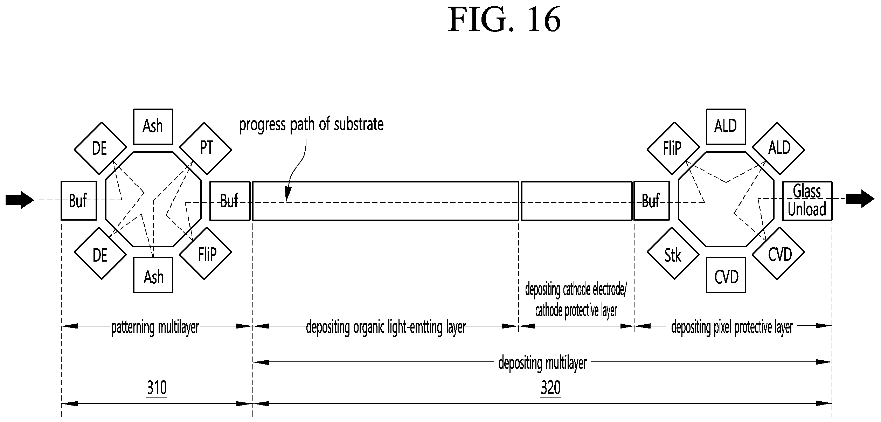

FIG. 15 illustrates a procedure of a manufacturing process of an organic light-emitting display device according to an embodiment. FIG. 16 illustrates a manufacturing system of an organic light-emitting display device according to an embodiment. FIGS. 17A to 17Q are cross-sectional views illustrating a manufacturing process of an organic light-emitting display device. FIGS. 17A to 17Q may be cross-sectional views cut along the line B-B' illustrated in FIGS. 10 and 11, and may be cross-sectional views cut along the line B-B' of FIGS. 1 and 2 when some processes are omitted.

### Step a: TFT formation

A plurality of thin film transistors TFT may be formed on a substrate 100 (step a). A first subpixel SPr, a second subpixel SPg, and a third subpixel SPb constituting a pixel may be defined on the substrate 100. A first driving circuit, a second driving circuit, and a third driving circuit may be configured to drive a first subpixel SPr, a second subpixel SPg, and a third subpixel SPb using a plurality of thin film transistors. An interlayer-insulating layer may be formed on the first driving circuit, the second driving circuit, and the third driving circuit.

### Step b: Anode formation (FIG. 17A)

As illustrated in FIG. 17A, the first anode electrode 141r to the third anode electrode 141b and the power wirings 111 and 112 may be formed on the interlayer-insulating layer (step b).

The first anode electrode 141r to the third anode electrode 141b and/or the power wirings 111 and 112 may comprise a metal or a conductive oxide, a metal alloy, etc. The first anode electrode 141r to the third anode electrode 141b and/or the power wirings 111 and 112 may comprise a single layer or different multilayer conductive films of a plurality of metals and metal alloys, conductive oxides.

The first anode electrode 141r to the third anode electrode 141b may be formed separately from each other in the first subpixel SPr to the third subpixel SPb. The power wirings 111 and 112 may be formed together with the first anode electrode 141r to the third anode electrode 141b, but is not limited thereto.

### Step c: Bank formation (FIG. 17B)

As illustrated in FIG. 17B, the bank 120 may be formed on the interlayer-insulating layer of the substrate 100 (step c).

The bank120 may surround the first anode electrode 141r to the third anode electrode 141b. In addition, the bank 120 can prevent an electrical short between the first anode electrode 141r to the third anode electrode 141b and between the first cathode electrode 143r to the third cathode electrode 143b to be formed later due to a step difference between each of the first anode electrode 141r to the third anode electrode 141b, and can prevent a disconnection between each of the first cathode electrode 143r to the third cathode electrode 143b.

The bank120 may comprise an organic material, an inorganic material, a metal oxide, etc. The organic material forming bank 120 may comprise, for example, a polyimide-based polymer or an acrylic-based polymer. The inorganic material forming bank 120 may comprise, for example, SiO₂, SiNx, SiON, Al₂O₃, etc. The bank120 may be formed of a single layer, an inorganic multilayer, or an organic and inorganic-mixed multilayer.

### Step d: Formation of a bank protective layer (FIG. 17B)

When bank 120 is formed of an organic material, an upper edge of bank 120 may be damaged during the etching and ashing process in the multilayer patterning step (step g, step j, and step m) or the contact hole patterning step (step p). When the upper edge of bank 120 is damaged, a bank protective layer 130 may be formed on bank 120.

The bank protective layer 130 may be formed of an inorganic material or an insulating oxide film. The bank protective layer 130 may be formed of a multilayer-inorganic material to secure a certain thickness. The inorganic material forming bank protective layer 130 may comprise SiO₂, SiNx, SiON, Al₂O₃, etc.

### Step e: Red multilayer deposition (FIG. 17C)

As illustrated in FIG. 17C, a red multilayer may be deposited on the substrate 100 (step e).

The red multilayer may refer to a plurality of layers constituting the first organic light-emitting element 140r and the first connecting pattern 140ra illustrated in FIG. 14. For example, a red organic light-emitting film 142', a red cathode film 143', and an insulating film 151-1 may be sequentially deposited on the substrate 100 to form a red multilayer. The multilayer deposition may effectively deposit 10 or more organic light-emitting layers, cathode layers, and cathode protective layers in an in-line deposition equipment configured with a plurality of chambers. The insulating film 151-1 may have a multilayer structure of an inorganic film comprising an ALD film. This is to prevent the red multilayer from being damaged by the penetration of the developer solution in the next process, i.e., the photo process, due to pinholes caused by foreign substances on the surface during the deposition process, and thus causing dark spots.

In addition, the inorganic film may be formed at a temperature of 100°C or less to prevent deformation of the organic light-emitting layer. Therefore, an organic film may be added as an intermediate film in the multilayer structure of the inorganic film to prevent damage such as penetration of a developer solution in the next process.

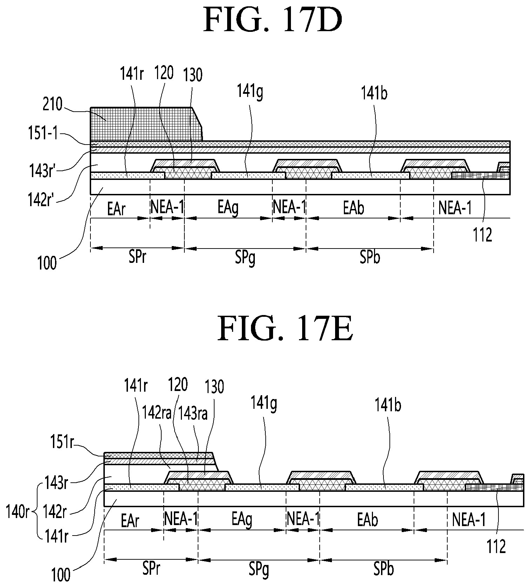

### Step f: Red multilayer photo (FIG. 17D)

The photo process (step f) may be performed on the formed red multilayer. Since the insulating film 151-1 having a multilayer structure consisting of an organic film and an inorganic film is formed on the entire surface of the substrate, the photo process may be performed without damage for a certain period of time at normal pressure on the cathode layer and organic light-emitting layer included in the red multilayer. However, since the photo process is atmospheric pressure, no matter how well the red multilayer is manufactured, it may be performed immediately to minimize environmental impact and then move on to the next process, i.e., the patterning process.

As illustrated in FIG. 17D, the red multilayer photo process may be performed first, so that a first photosensitive pattern 210 may be formed on the red multilayer (step f).

### Step g: Red multilayer patterning (FIG. 17E)

In general, the term 'patterning' is a general term for a series of processes that etch and remove (strip) the photoresist after the photo (exposure, development). However, it should be noted that in the present invention, dry etching and ashing performed in a vacuum equipment, excluding the photo, are collectively called patterning.

The insulating film 151-1 may be etched by dry etching using CF₄ based gas, then the red cathode film 143r' may be etched by dry etching using Cl₂ or HCl based gas, and then the organic light-emitting film 142r' may be dry etched by CF₄ based gas, and then the first photosensitive pattern 210 may be removed by ashing with O₂. In addition to these based gases, the added gas may be an inert gas such as Ar or He, and depending on the films, O₂ or H₂, but is not limited thereto.

In the step g, the first organic light-emitting layer 142r and the first cathode electrode 143r of the first organic light-emitting element 140r, and the first extended organic light-emitting layer 142ra, the first extended cathode electrode 143ra, and the first subpixel protective layer 151r of the first connecting pattern 140ra may be formed.

The first organic light-emitting layer 142r and the first extended organic light-emitting layer 142ra may be formed using the red organic light-emitting film 142'. The first cathode electrode 143r and the first extended cathode electrode 143ra may be formed using the red cathode film 143'. The first subpixel protective layer 151r may be formed using the insulating film 151-1. The first subpixel protective layer 151r may also be formed on the first cathode electrode 143r and/or the first extended cathode electrode 143ra.

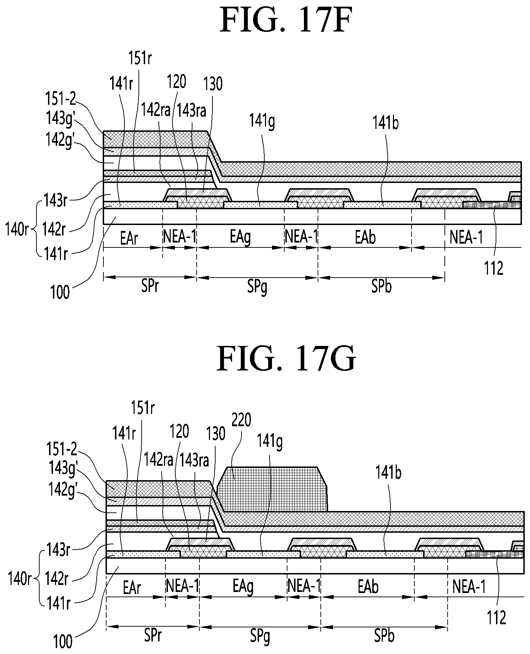

Specifically, as illustrated in FIG. 17D, a red multilayer photo process may be first performed, so that the first photosensitive pattern 210 may be formed on the red multilayer (step f). Thereafter, it moves to a plurality of vacuum chambers for dry etching and dry ashing, and the step g and the step h may be performed continuously in a vacuum atmosphere in all processes. That is, as illustrated in FIG. 17E, after the red multilayer is patterned in a vacuum atmosphere (step g), as illustrated in FIG. 17F, the green multilayer may be deposited in a vacuum atmosphere (step h).

The red multilayer may be patterned (step g), so that the first organic light-emitting layer 142r and the first cathode electrode 143r of the first organic light-emitting element 140r, the first extended organic light-emitting layer 142ra and the first extended cathode electrode 143ra of the first connecting pattern 140ra, and the first subpixel protective layer 151r may be formed. In this instance, a lateral surface of the first extended cathode electrode 143ra of the first connecting pattern 140ra may be exposed.

In the step e, when the substrate 100 is moved to a photo equipment in an ambient atmosphere to perform step f while the insulating film 151-1 constituting the red multilayer is not formed, the upper surface of the first cathode electrode 143r of the first organic light-emitting element 140r and the upper surface of the first extended cathode electrode 143ra of the first connecting pattern 140ra may be exposed to the ambient atmosphere, so that the upper surface of the first cathode electrode 143r of the first organic light-emitting element 140r and the upper surface of the first extended cathode electrode 143ra may be oxidized, thereby losing their function as electrodes and causing a dark spot defect.

However, in the embodiment, since the insulating film 151-1 constituting the red multilayer is formed on the upper surface of the red cathode film 143', even if the substrate 100 is moved to a photo equipment in an ambient atmosphere to perform step f, the upper surface of the first cathode electrode 143r of the first organic light-emitting element 140r and the upper surface of the first extended cathode electrode 143ra of the first connecting pattern 140ra are not exposed to the ambient atmosphere by the first subpixel protective layer 151r, so that a dark spot defect can be prevented.

Meanwhile, even if the insulating film 151-1 constituting the red multilayer is formed and the dark spot defect is prevented, at least a lateral surface of the first extended cathode electrode 143ra of the first connecting pattern 140ra may be exposed as a result of step g. When the lateral surface of the first extended cathode electrode 143ra exposed above is not subjected to step h and the substrate 100 is moved to a photo equipment in an ambient atmosphere to perform the step i immediately, the lateral surface of the first extended cathode electrode 143ra exposed above may be exposed to the ambient atmosphere, and the lateral surface of the first extended cathode electrode 143ra may be oxidized.

However, in the embodiment, step h may be continuously performed in a vacuum atmosphere after the step g, so that a green multilayer may be formed on the first organic light-emitting element 140r and the first connecting pattern 140ra, and thus the lateral surface of the first extended cathode electrode 143ra of the first connecting pattern 140ra is not exposed by the green multilayer. Even if the substrate 100 is moved to a photo equipment and exposed to an ambient atmosphere to perform step i thereafter, the lateral surface of the first extended cathode electrode 143ra may not be oxidized by oxygen, etc.

In summary, in the embodiment, when the red multilayer is formed, the insulating film 151-1 for forming the first subpixel protective layer 151r on the uppermost layer may be formed, so that oxidation of the first cathode electrode 143r of the first organic light-emitting element 140r and the first extended cathode electrode 143ra of the first connecting pattern 140ra can be prevented. In addition, in the embodiment, after the green multilayer is formed in a state where the red multilayer is patterned and at least a lateral surface of the first extended cathode electrode 143ra of the first connecting pattern 140ra is exposed (step g), the substrate 100 may be moved to a photo equipment in an ambient atmosphere to perform step i. In this instance, since the green multilayer is formed on the entire surface of the substrate, the lateral surface of the first extended cathode electrode 143ra is not exposed, and thus it may not be oxidized by oxygen, etc. In addition, both the step g and the step h may be processes performed in a vacuum atmosphere, and a system may be required in which the processes are continuously moved in-line manner between the vacuum chambers and performed, so that the process time can be greatly shortened, thereby improving productivity, ensuring quality through the management of foreign substances, and reducing expensive material costs. Therefore, a 'vacuum patterning and deposition in-line system' that may satisfy yield, productivity, and material costs may be implemented.

### step h: Green multilayer deposition (FIG. 17F)

As described above, after the R multilayer patterning (step g) is completed, it may be moved to a logistics that maintains a vacuum atmosphere. For example, it may be moved to a vacuum deposition chamber through atmospheric pressure logistics where oxygen or moisture is managed to be 5 ppm or less. When it does not move through the logistics as above, an oxidation reaction with oxygen or moisture may occur on a lateral surface of the etched red multilayer, causing the cathode layer (cathode electrode), the electron injection layer, and the charge generation layer (comprising Mg, Ag, LiF, Li, Yb, etc.) to deteriorate in function, or as time passes, oxygen or moisture may diffuse and damage the organic light-emitting material, causing dark spots. Therefore, implementation of vacuum logistics or its system is essential.

As illustrated in FIG. 17F, a green multilayer may be formed in a vacuum atmosphere (step h).

The green multilayer may mean a plurality of layers constituting the second organic light-emitting element 140g and the second connecting pattern 140ga. For example, a green organic light-emitting film 142g', a green cathode film 143g', and an insulating film 151-2 may be sequentially formed on the substrate 100, thereby forming a green multilayer.

The green multilayer deposition (step h) is the same process as the red multilayer deposition (step e) except that it applies the second organic light-emitting layer 142g among the organic deposition materials, applies some layers optimized for the second organic light-emitting layer 142g, and optimizes the thickness to the green wavelength, and thus, further descriptions will be omitted (FIG. 17F).

### Step i: Green multilayer photo (FIG. 17G)

As illustrated in FIG. 17G, a green multilayer photo process may be performed, so that a second photosensitive pattern 220 may be formed on the green multilayer (step i).

The green multilayer photo (step i) is the same process as the red multilayer photo (step f), and thus, further descriptions will be omitted.

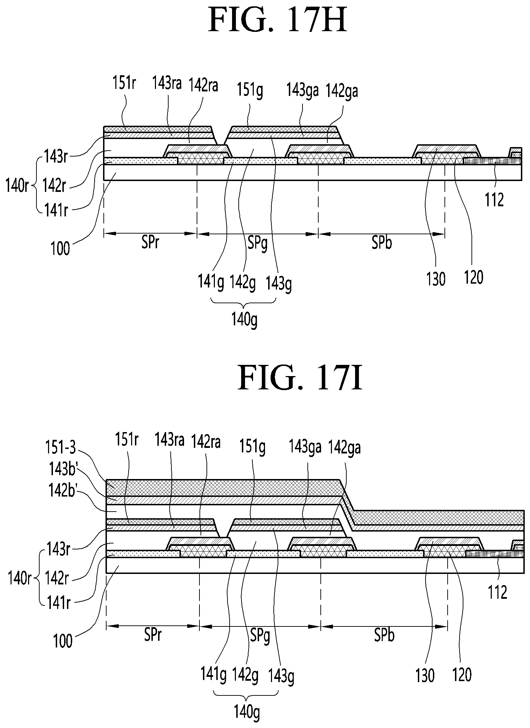

### Step j: Green multilayer patterning (FIG. 17H)

A dry etching process and a dry ashing process may be performed on the formed green multilayer, so that a second organic light-emitting layer 142g and a second cathode electrode 143g of a second organic light-emitting element 140g and a second extended organic light-emitting layer 142ga, a second extended cathode electrode 143ga, and a second subpixel protective layer 151g of a second connecting pattern 140ga may be formed (step j).

The green multilayer patterning (step j) is the same process as the red multilayer patterning (step g), so that further descriptions will be omitted (FIG. 17H).

### Step k: Blue multilayer deposition (FIG. 17I)

As described above, when the step j is completed, the step k may be continuously performed while maintaining a vacuum. That is, as illustrated in FIG. 17H, after the green multilayer is patterned in a vacuum atmosphere (step j), as illustrated in FIG. 17I, the green multilayer may be deposited on a vacuum deposition line (step k).

The blue multilayer deposition (step k) is the same process as the red multilayer deposition (step e) except that it applies the third organic light-emitting layer 142b among the organic deposition materials and applies some layers optimized for the third organic light-emitting layer 142b, and optimizes the thickness to the blue wavelength, so further descriptions will be omitted (FIG. 17I).

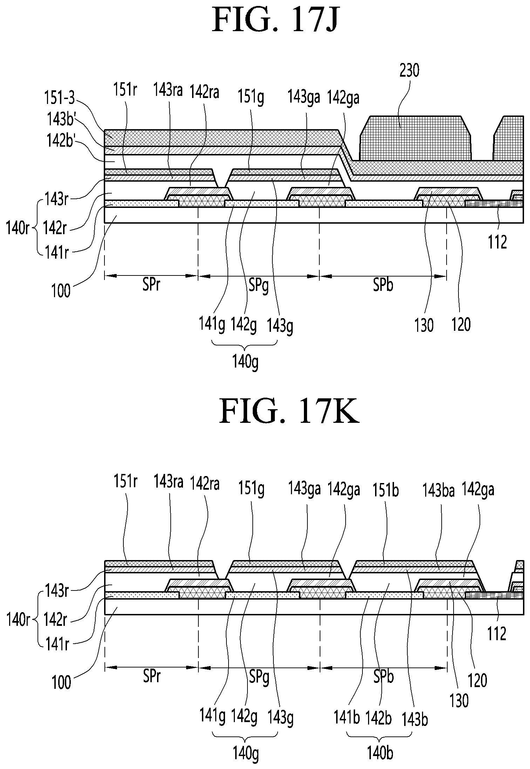

### Step l: Blue multilayer photo (FIG. 17J)

As illustrated in FIG. 17J, a photo process may be performed, so that the third photosensitive pattern 230 may be formed on the blue multilayer (step l).

The blue multilayer photo (step l) is the same process as the red multilayer photo (step f), and detailed descriptions thereof will be omitted (FIG. 17J).

### Step m: Blue multilayer patterning (FIG. 17K)

A dry etching process and a dry ashing process may be performed on the blue multilayer formed above, so that the third organic light-emitting layer 142b and the third cathode electrode 143b of the third organic light-emitting element 140b, and the third extended organic light-emitting layer 142ba, the third extended cathode electrode 143ba, and the third subpixel protective layer 151b of the third connecting pattern 140ba may be formed.

The third organic light-emitting layer 142b and the third extended organic light-emitting layer 142ba may be formed using the blue organic light-emitting film 142b'. The third cathode electrode 143b and the third extended cathode electrode 143ba may be formed using the blue cathode film 143b'. The third subpixel protective layer 151b may be formed using the insulating film 151-3. The third subpixel protective layer 151b may be formed on the third cathode electrode 143b and/or the third extended cathode electrode 143ba.

The blue multilayer patterning (step m) is the same process as red multilayer patterning (step g), so that further descriptions will be omitted (FIG. 17K).

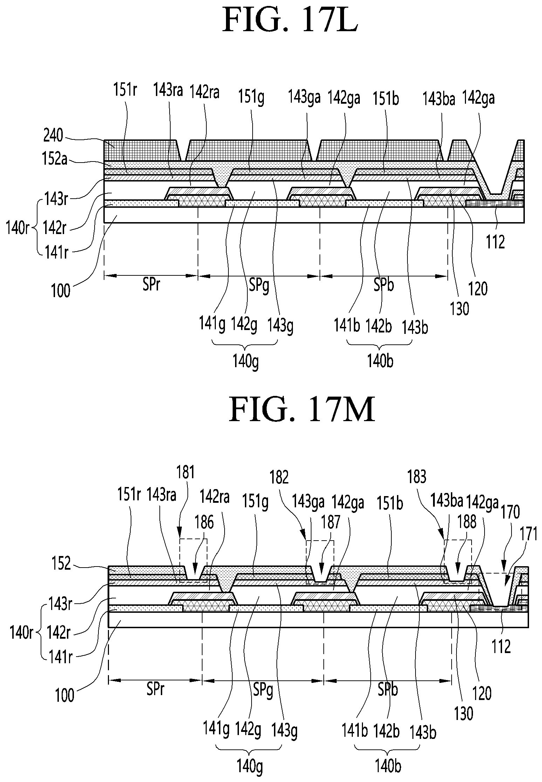

### Step n: Pixel protective layer deposition (FIG. 17L)

As illustrated in FIG. 17J, a blue multilayer photo process may be first performed, so that a third photosensitive pattern 230 may be formed on the blue multilayer (step l). Thereafter, the step m and the step n may be performed sequentially while moving between the chambers while maintaining a vacuum. That is, as illustrated in FIG. 17K, after the blue multilayer is patterned in a vacuum atmosphere (step m), as illustrated in FIG. 17L, a pixel protective film 152a may be deposited in a vacuum atmosphere (step n).

As a result of the m step, the third organic light-emitting layer 142b and the third cathode electrode 143b of the third organic light-emitting element 140b, the third extended organic light-emitting layer 142ba, the third extended cathode electrode 143ba, and the third subpixel protective layer 151b of the third connecting pattern 140ba may be formed. In this instance, the lateral surface of the third extended cathode electrode 143ba of the third connecting pattern 140ba may be exposed.

As illustrated in FIGS. 17E, 17H, and 17K, the first cathode electrode 143r, the second cathode electrode 143g, the third cathode electrode 143b, etc., may comprise a metal, an oxide conductive film, a metal alloy, etc. As the metal for the cathode electrode, Ag, Al, Zn, In, Sn, Mg:Ag, Ca:Ag, etc., which have a work function of 4.0 eV or higher, are easy to dry etch, and have good reflectivity, may be used. When the cathode electrode has a double structure, Zn, Sn, and Ag may be provided among the metals in consideration of the problem of contact resistance with the bridge electrode as an upper layer, or a contact resistance due to the reaction with the etching gas in the dry etching process for removing the film on the upper part of the cathode electrode. ITO, IZO, etc., may be used as the oxide conductive film. In addition, the first cathode electrode 143r, the second cathode electrode 143g, the third cathode electrode 143b, etc., may be a single layer or comprise different multilayer conductive films.

As illustrated in FIGS. 17E, 17H, and 17K, the first subpixel protective layer 151r, the second subpixel protective layer 151g, and the third subpixel protective layer 151b may prevent damage to the first organic light-emitting layer 142r, the second organic light-emitting layer 142g, and the third organic light-emitting layer 142b during the photo process and the etching process. The first subpixel protective layer 151r, the second subpixel protective layer 151g, and/or the third organic light-emitting layer 142b may comprise an insulating organic material, an insulating inorganic material, an insulating oxide film, or a multilayer film composed of these. Polyimide may be used as the organic material, SiO₂, SiON, SiNx, etc., may be used as the inorganic material, and Al2O3, etc., may be used as the insulating oxide film.

In the step k, when the substrate 100 is moved to a photo equipment in an ambient atmosphere to perform step l while the insulating film 151-3 constituting the blue multilayer is not formed, the upper surface of the third cathode electrode 143b of the third organic light-emitting element 140b and the upper surface of the third extended cathode electrode 143ba of the third connecting pattern 140ba may be exposed to the ambient atmosphere, so that the upper surface of the third cathode electrode 143b of the third organic light-emitting element 140b and the upper surface of the third extended cathode electrode 143ba may be oxidized, thereby losing their function as electrodes and causing a dark spot defect.

However, in the embodiment, since the insulating film 151-3 constituting the blue multilayer is formed on the upper surface of the blue cathode film 143b', even if the substrate 100 is moved to a photo equipment in an ambient atmosphere to perform the step l, the upper surface of the third cathode electrode 143b of the third organic light-emitting element 140b and the upper surface of the third extended cathode electrode 143ba of the third connecting pattern 140ba are not exposed to the ambient atmosphere by the third subpixel protective layer 151b, so that a dark spot defect can be prevented.

Meanwhile, even if the insulating film 151-3 constituting the blue multilayer is formed and the dark spot defect is prevented, at least a lateral surface of the third extended cathode electrode 143ba of the third connecting pattern 140ba may be exposed as a result of the step m. When the lateral surface of the exposed third extended cathode electrode 143ba is exposed to the ambient atmosphere when the substrate 100 is moved to the photo equipment in the ambient atmosphere to perform the step l immediately without performing the step n, the lateral surface of the exposed third extended cathode electrode 143ba may be oxidized.

However, in the embodiment, the step n may be continuously performed in a vacuum atmosphere after the m step, so that the pixel protective layer 152 may be formed on the third organic light-emitting element 140b and the third connecting pattern 140ba, and thus the lateral surface of the third extended cathode electrode 143ba of the first connecting pattern 140ra is not exposed by the pixel protective layer 152. Even if the substrate 100 is moved to the photo equipment and exposed to the ambient atmosphere to perform the step l thereafter, the lateral surface of the third extended cathode electrode 143ba may not be oxidized by oxygen, etc.

In summary, in the embodiment, when the blue multilayer film is formed, the insulating film 151-3 for forming the third subpixel protective layer 151b on the uppermost layer may be formed, thereby preventing oxidation of the third cathode electrode 143b of the third organic light-emitting element 140b and the third extended cathode electrode 143ba of the third connecting pattern 140ba. In addition, in the embodiment, when the blue multilayer is patterned and at least the lateral surface of the third extended cathode electrode 143ba of the third connecting pattern 140ba is exposed (step m), after the pixel protective layer 152 is formed, the substrate 100 may be moved to a photo equipment in an ambient atmosphere to perform a contact hole photo process (step o). In this instance, since the lateral surface of the third extended cathode electrode 143ba is not exposed by the pixel protective layer 152, it can be prevented from being oxidized by oxygen, etc.

As described above in 'the step g patterning to the step h deposition' and 'the step j pattern to the step k deposition', in the patterning process, the substrate may be performed face-up, and in the deposition process, the substrate may be performed face-down. Therefore, various additional mechanical operations, such as the substrate being flipped over, moved with a chuck, and aligned and mounted on a tray before or after moving between the chambers in a vacuum atmosphere, may be required. However, since the step m and the step n are performed continuously, both processes may be face-up processes, a system may be created in which logistics movement between 'process chambers' is possible using a robot arm within a 'cluster chamber'. Therefore, since the step m and the step n are performed continuously in a cluster manner in a vacuum atmosphere, the process time can be significantly shortened, which improves productivity, and since foreign matter management is easy, product quality can be improved.

In summary, the manufacturing system in the embodiment may perform patterning of a red multilayer and deposition of a green multilayer, patterning of the green multilayer and deposition of a blue multilayer, and patterning of the blue multilayer and deposition of a pixel protective layer, respectively. In this instance, equipment comprising a dry etching and an ashing process, that is, a 'multilayer patterning equipment', and an 'in-line deposition equipment' comprising a deposition process of an organic light-emitting film and a deposition process of a cathode film are connected by vacuum logistics, and a manufacturing system having a chamber or function for flipping over a substrate in a connecting section may be required.

In the above, the red multilayer, the green multilayer, and the blue multilayer may be called a first multilayer, a second multilayer, and a third multilayer, respectively.

Meanwhile, by performing the step n, a pixel protective film 152a may be formed. As illustrated in FIG. 17L, a pixel protective film 152a may be formed on a display region of the substrate 100. Accordingly, a lateral surface of the exposed first extended cathode electrode 143ra, a lateral surface of the exposed second extended cathode electrode 143ga, and a lateral surface of the exposed third extended cathode electrode 143ba may be protected by the pixel protective film 152a.

### Step: Contact hole photo (FIG. 17L)

The photo process (step o) and the etching process (step p) may be performed so that the first cathode contact hole 186 of the first cathode connecting structure 181 may be formed in the non-emission region NEA-1 and NEA-2 of the first subpixel SPr, the second cathode contact hole 187 of the second cathode connecting structure 182 may be formed in the non-emission region NEA-1 and NEA-2 of the second subpixel SPg, and the third cathode contact hole 188 of the third cathode connecting structure 183 may be formed in the non-emission region NEA-1 and NEA-2 of the third subpixel SPb.

Specifically, as illustrated in FIG. 17L, first, a contact hole photo process may be performed, so that the fourth photosensitive pattern 240 may be formed on the pixel protective film 152a (step o).

### Step p: Contact hole patterning (FIG. 17M)

As illustrated in FIG. 17M, after the pixel protective film 152a and the first subpixel protective layer 151r to the third subpixel protective layer 151b are patterned in the dry etching equipment (step p), the fourth photosensitive pattern 240 may be removed in the ashing equipment, and then the substrate may be moved to a sputtering equipment that forms a bridge electrode by a vacuum-maintaining logistics. When the bridge electrode is not formed by the sputtering equipment but by a vacuum evaporation method, a substrate inversion chamber similar to the aforementioned manufacturing system may be equipment included in the vacuum logistics.

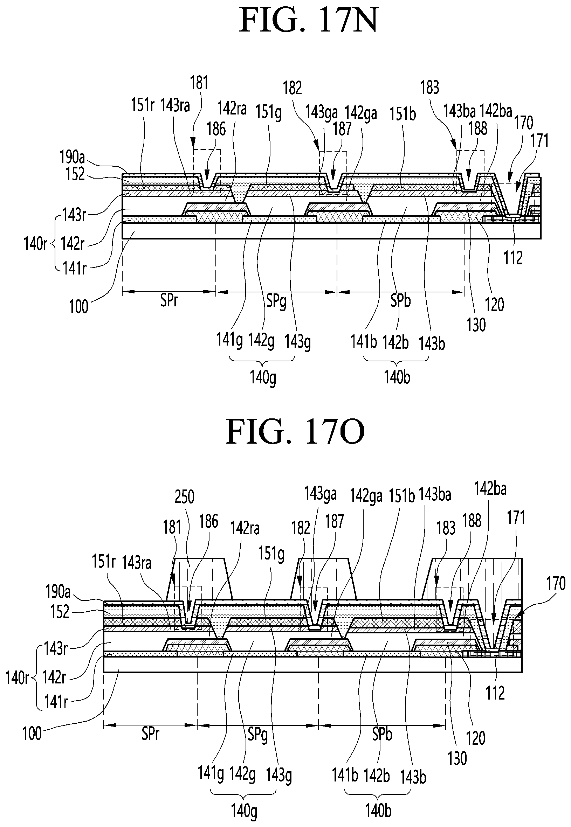

As illustrated in FIG. 17N, a bridge electrode 190a may be formed in a sputtering equipment or a vacuum deposition equipment (step q).

The step p and the step q may be performed sequentially in a vacuum atmosphere, but is not limited thereto.

As a result of the step p, a first cathode contact hole 186 of the first cathode connecting structure 181, a second cathode contact hole 187 of the second cathode connecting structure 182, and a third cathode contact hole 188 of the third cathode connecting structure 183 may be formed. In this instance, an upper surface of the first extended cathode electrode 143ra of the first connecting pattern 140ra, an upper surface of the second extended cathode electrode 143ga of the second connecting pattern 140ga, and an upper surface of the third extended cathode electrode 143ba of the third connecting pattern 140ba may be exposed through the first cathode contact hole 186, the second cathode contact hole 187, and the third cathode contact hole 188.

In addition, as a result of the step p, the pixel protective layer 152 may be formed in the display region of the substrate 100 except for the first cathode contact hole 186 to the third cathode contact hole 188. In addition, the power contact hole 171 of the power connecting structure 170 may be formed on the power wirings 111 and 112 (FIG. 17M).

Meanwhile, when using oxygen gas in the process of forming contact holes 186, 187, 188, and 171 by dry etching and performing ashing to remove residual photoresist, the surface of the exposed cathode electrodes may be oxidized, which may affect the contact resistance, so that care must be taken in selecting the cathode material as described above, both in terms of the process and as described above. Therefore, in order to secure the display performance of the structures of the example in the process of forming contact holes, a key process management item is the management of the contact resistance between the cathode electrodes and the bridge electrode. When there is a partial difference, a color spot defect or, in severe cases, a dark spot defect may occur, and when it is high overall, power consumption may increase.

When selecting the type of gas for dry etching depending on the material of the cathode electrode, care must be taken not to comprise argon or oxygen when the cathode electrode is magnesium (Mg) or silver (Ag). When used, the surface of the cathode electrode may be oxidized or the film of the cathode electrode may be etched.

In addition, as described above, during dry etching of the inorganic film, a stable cathode electrode structure that may not be etched or oxidized, and even if oxidized, has low connection resistance with the bridge electrode may be required. For example, in a double film, a lower layer may be a layer that contacts the electron injection layer (EIL), and an upper layer may be designed with a structure using a material that has low contact resistance even if partially oxidized to contact the bridge electrode. Ag, Al, Zn, In, Sn, Mg:Ag, Ca:Ag, etc., are effective for the lower layer (electron injection cathode), and it may be preferable to use Zn, Sn, Ag, ITO, IZO, etc., for the upper layer (bridge contact cathode).

The electron injection layer (EIL) to be connected to these new cathode electrodes is preferably made of ytterbium (Yb), yttrium (Y), lithium (Li), sodium (Na), potassium (K), rubidium (Rb), cesium (Cs), calcium (Ca), strontium (Sr), barium (Ba), radium (Ra), scandium (Sc), lanthanum (La), cerium (Ce), ruthenium (Ru), and samarium (Sm), which have relatively low work functions (4.0 eV or less).

### Step q: Bridge electrode deposition (FIG. 17N)

The bridge electrode 190a comprises a metal, an oxide conductive film, a metal alloy, an organic conductive film, etc., and may comprise a single layer or different multilayer conductive films. When it is not transparent, it may be Al, Al alloy, Mo, MoTi or a double or triple layer containing them, which are easy to dry etch and have relatively low resistance. For example, it may be Mo/Al/Mo, MoTi/Al/MoTi, Al/Mo, Al/MoTi. The transparent conductive film may be IZO, ITO, but is not limited thereto.

When the substrate 100 is moved to a photo equipment in an ambient atmosphere to perform the step r immediately without performing the step q, the upper surfaces of the first extended cathode electrode 143ra to the third extended cathode electrode 143ba exposed in the exposed contact holes 186, 187 and 188 may be oxidized.

However, in the embodiment, the step q may be performed continuously in a vacuum atmosphere after the step p, so that the bridge electrode 190 may be formed at least in the first cathode contact hole 186 to the third cathode contact hole 188, so that the upper surface of the first extended cathode electrode 143ra to the third extended cathode electrode 143ba is not exposed by the bridge electrode 190. Even if the substrate 100 is moved to the photo equipment and exposed to the ambient atmosphere to perform the step l thereafter, the upper surface of the first extended cathode electrode 143ra to the third extended cathode electrode 143ba may not be oxidized by oxygen, etc.

In summary, in the embodiment, in a state where the upper surfaces of the first extended cathode electrode 143ra to the third extended cathode electrode 143ba are exposed through the first cathode contact hole 186 to the third cathode contact hole 188 (step p), the substrate 100 may be moved to a photo equipment in an ambient atmosphere to perform the step r after the bridge electrode 190 is formed. In this instance, since the upper surfaces of the first extended cathode electrode 143ra to the third extended cathode electrode 143ba are not exposed by the bridge electrode 190, they may not be oxidized by oxygen, etc. In addition, since the step p and the step q are continuously performed in-line in a vacuum atmosphere, the process time can be significantly shortened, thereby improving productivity, and since foreign matter management is easy, product quality can be improved.

Meanwhile, since the step q is performed, the bridge electrode 190 may be formed. As illustrated in FIG. 17N, the bridge electrode 190 may be formed on the display region of the substrate 100.

### step r: Bridge electrode photo (FIG. 17O)

In addition, a photo process (step r) and an etching process (step s) may be performed, so that the bridge electrode 190 may be formed in various shapes (FIG. 1, FIG. 2, FIG. 10, FIG. 11).

Specifically, as illustrated in FIG. 17O, a bridge electrode photo process may be first performed, so that a fifth photosensitive pattern 250 may be formed on the bridge electrode (step r).

Thereafter, the step s and the step t may be performed sequentially in a vacuum atmosphere, but is not limited thereto.

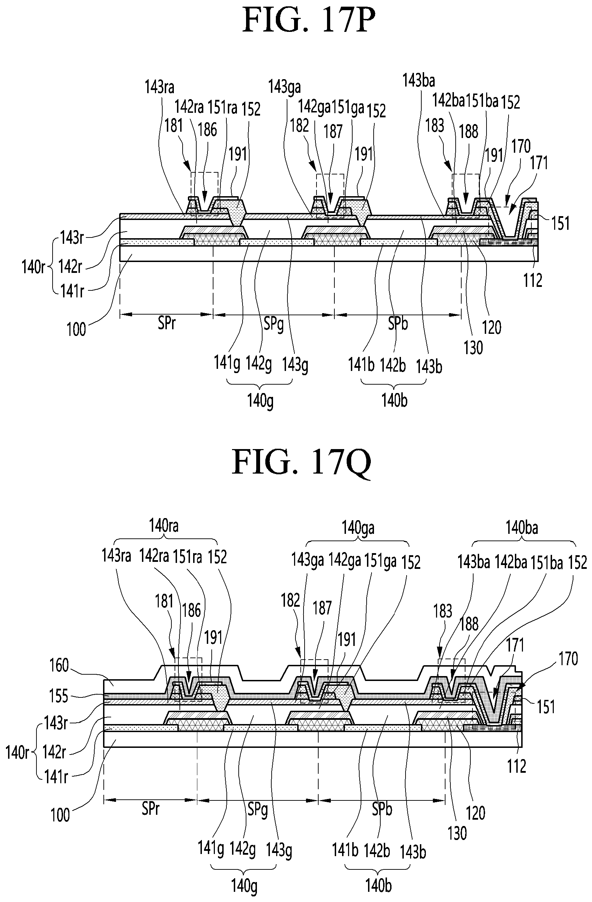

### step s: Bridge electrode patterning (FIG. 17P)

As illustrated in FIG. 17P, after dry etching the bridge electrode 190 in a vacuum atmosphere (step s), not only the bridge electrode 190 but also the pixel protective layer 152 and the first subpixel protective layer 151r to the third subpixel protective layer 151b may be removed. Since the bridge electrode 190, the pixel protective layer 152, and the first subpixel protective layer 151r to the third subpixel protective layer 151b are removed through the fifth photosensitive pattern 250, the pixel protective layer 152 and the first subpixel protective layer 151r to the third subpixel protective layer 151b may be patterned corresponding to the shape of the patterned bridge electrode 190.

In this instance, when the vacuum is maintained while the upper parts of the cathode electrodes 143r, 143g, and 143b are all removed and the next process is not performed, the cathode electrodes 143r, 143g, and 143b may be oxidized, and the organic light-emitting layers 142r, 142g, and 142b are damaged by moisture and oxygen (step s).

In addition, the reason for removing the pixel protective layer 152 and the subpixel protective layers 151r, 151g, and 151b, which are disposed on the upper parts of the cathode electrodes 143r, 143g, and 143b, may be that the light extraction efficiency can be improved in terms of product performance, but from the perspective of the process for improving the yield, it may be because it is easy to repair the organic light-emitting element before proceeding to the next process, step t (encapsulation deposition, FIG. 17Q).

The repair method may apply a reverse voltage to the organic light-emitting element in an atmosphere containing a small amount of oxygen or moisture while maintaining a vacuum with the cathode electrodes 143r, 143g, and 143b exposed. In this instance, when pixel protective layer 152 and the subpixel protective layers 151r, 151g and 151b are disposed on an upper part of the cathode electrodes 143r, 143g and 143b, repair may not be possible because oxygen does not reach or the cathode electrode is not partially removed thermally. Therefore, by removing the upper layers, i.e., the pixel protective layer 152 and the subpixel protective layers 151r, 151g and 151b, disposed on the cathode electrodes 143r, 143g and 143b, the cathode electrodes 143r, 143g and 143b may be partially oxidized or removed by overcurrent in a subpixel in which the organic light-emitting element is in a state of electrical leakage or short-circuiting and becoming a dark spot. Through this process, the subpixels that are dark spots may be repaired into normal subpixels again. The yield can be improved due to the rapid reduction in the number of dark spots per panel (from 100 to 3), which is a key specification of a good panel.

### step t: Encapsulation layer deposition (FIG. 17Q)

Therefore, by transporting the substrate while maintaining a vacuum, the cathode protective layer 155 and the encapsulation layer 160 may be formed in equipment in which the vacuum deposition chamber and the PECVD chamber are connected in in-line manner (Fig. 17q). As a result of proceeding in this manner, the organic light-emitting display device according to the sixth embodiment (Fig. 12) and the seventh embodiment (Fig. 13) may be manufactured.

In addition, in the manufacturing process for the structures of the sixth embodiment (FIG. 12) and the seventh embodiment (FIG. 13), the patterned pixel protective layer 152 may be disposed on the lateral surface of the first extended organic light-emitting layer 142ra of the first connecting pattern 140ra, the lateral surface of the second extended organic light-emitting layer 142ga of the second connecting pattern 140ga, and the lateral surface of the third extended organic light-emitting layer 142ba of the third connecting pattern 140ba. The first extended organic light-emitting layer 142ra, the second extended organic light-emitting layer 142ga, and the third extended organic light-emitting layer 142ba may be formed by extending from the first organic light-emitting layer 142r, the second organic light-emitting layer 142g, and the third organic light-emitting layer 142b, respectively. The first organic light-emitting layer 142r, the second organic light-emitting layer 142g, and the third organic light-emitting layer 142b may comprise at least one or more low-resistance layer, such as a charge generation layer or a hole injection layer.

When the bridge electrode 190 is in contact with the lateral surface of the first extended organic light-emitting layer 142ra, the lateral surface of the second extended organic light-emitting layer 142ga, and the lateral surface of the third extended organic light-emitting layer 142ba, an electrical short may occur between them, which may cause a dark spot defect. However, in the embodiment, the bridge electrode 190 may be electrically insulated from the lateral surface of the first extended organic light-emitting layer 142ra, the lateral surface of the second extended organic light-emitting layer 142ga, and the lateral surface of the third extended organic light-emitting layer 142ba by the patterned pixel protective layer 152, so that an electrical short or current leakage between the bridge electrode 190 and the first extended organic light-emitting layer 142ra to the third extended organic light-emitting layer 142ba may be blocked, thereby preventing a dark spot defect or a color spot defect.

Meanwhile, as a result of the step s, the upper surface of the first cathode electrode 143r of the first organic light-emitting element 140r, the upper surface of the second cathode electrode 143g of the second organic light-emitting element 140g, and the upper surface of the third cathode electrode 143b of the third organic light-emitting element 140b may be exposed. The upper surface of the first extended cathode electrode 143ra of the first connecting pattern 140ra, the upper surface of the second extended cathode electrode 143ga of the second connecting pattern 140ga, and the upper surface of the third extended cathode electrode 143ba of the third connecting pattern 140ba may be exposed, but is not limited thereto.

In the embodiment, the transfer process from the step s to the step t may be continuously performed in a vacuum atmosphere, and the encapsulation layer 160 may be formed as a film on the substrate 100, so that the upper surfaces of the cathode electrodes 143r, 143g, and 143b of the organic light-emitting elements 140r, 140g, and 140b and the upper surfaces of the extended cathode electrodes 143ra, 143ga, and 143ba of the connecting patterns 140ra, 140ga, and 140ba may be covered by the encapsulation layer 160 and are not exposed. Accordingly, even if the substrate 100 is exposed to an ambient atmosphere, the upper surface is not exposed by the encapsulation layer 160, so that it may not be oxidized by oxygen, etc.

In addition, since the step s and the step t are continuously performed in a vacuum atmosphere in an in-line manner, the process time can be significantly shortened, thereby improving productivity, and foreign matter management is easy, thereby improving product quality.

As illustrated in FIG. 17Q, the cathode protective layers 145r, 145g, and 145b may be formed on the substrate 100 before the encapsulation layer 160 is formed, but is not limited thereto.

Although not illustrated, the cathode protective layers 145r, 145g, and 145b may also be formed using photo and etching when individually forming the first subpixel SPr, the second subpixel SPg, and the third subpixel SPb. That is, as illustrated in FIG. 17C, the first cathode protective layer 145r may be formed on the red cathode film 143r', and the insulating film 151-1 may be formed on the first cathode protective layer 145r. As illustrated in FIG. 17F, the second cathode protective layer 145g may be formed on the green cathode film 143g', and the insulating film 151-2 may be formed on the second cathode protective layer 145g. As illustrated in FIG. 17I, the third cathode protective layer 145b may be formed on the blue cathode film 143b', and the insulating film 151-3 may be formed on the third cathode protective layer 145b.

Thereafter, another encapsulation layer may be added on the encapsulation layer 160 (u step), and the substrate 100 described above may be bonded to the upper substrate 100, so that an organic light-emitting display device according to the embodiment illustrated in FIG. 14 may be manufactured.

Meanwhile, although not illustrated, after completing the contact hole patterning (step p) in FIG. 17M, in the step of depositing a bridge electrode film in FIG. 17N, a cell mask that covers the non-display region for each cell and forms a film only in the display region is mounted on the sputtering equipment, and a transparent conductive film may be deposited in the display region, and then the bridge electrode photo process (step r) and the bridge electrode patterning process (step s) may be omitted, and the encapsulation layer deposition process (step t) may be performed, so that an organic light-emitting display device according to the fourth embodiment (FIG. 8) and the fifth embodiment (FIG. 9) may be manufactured.

Also, although not illustrated, in the bridge electrode patterning (step s), only the bridge electrode 190 may be etched, and the pixel protective layer 152 and the first subpixel protective layer 151r to the third subpixel protective layer 151b may not be removed. After only the bridge electrode 1190 is patterned through the fifth photosensitive pattern 250, the fifth photosensitive pattern may be removed (strip or ashing), and the encapsulation layer 160 may be formed. As a result of proceeding in this way, when there is no pixel protection layer, an organic light-emitting display device according to the first embodiment (Fig. 4) may be manufactured, when there is a pixel protection layer 152 and it is an inorganic material, an organic light-emitting display device according to the second embodiment (Fig. 5) may be manufactured, and when the pixel protection layer 152 is an organic material, an organic light-emitting display device according to the third embodiment (Fig. 6) may be manufactured.

Meanwhile, the steps g and h, the steps j and k, and the steps m and n in FIG. 15 may be performed in the manufacturing system of the organic light-emitting display device according to the embodiment illustrated in FIG. 16, respectively.

As illustrated in FIG. 16, the manufacturing system of the organic light-emitting display device according to the embodiment may be implemented in an in-line manner. The manufacturing system of the organic light-emitting display device according to the embodiment may largely comprise a patterning equipment 310 and a deposition equipment 320.

The patterning equipment 310 may be provided with a robot arm in the center of a cluster chamber, and a plurality of chambers may be installed in a ring shape.

The plurality of chambers may comprise a loading chamber, a dry etcher DE, an asher Ash, a plasma treatment chamber PT, a flip chamber, a buffer chamber Buf, etc.

The loading chamber may be an entrance for loading the substrate 100 into the patterning equipment 310. The robot arm may transport and return the substrate 100 loaded through the loading chamber to the corresponding chamber according to a preset order.

The dry etcher DE may be a member for etching a specific portion on the substrate 100 to form a pattern. The asher Ash may be a member for removing a photosensitive pattern. The plasma treatment chamber PT may be a member for removing organic components that may remain on the surface of the anode electrode during the dry etching process and the ashing process, and for uniformizing and stabilizing the work function of the anode across the entire surface of the substrate. The flip chamber may be a member for rotating the substrate 100 so that the substrate, which has been processed in a face-up state in the patterning equipment, may be input into the deposition equipment in a face-down state. The buffer chamber may be a member for connecting the patterning equipment 310 and the deposition equipment 320. The substrate 100, on which the patterning process is completed by the patterning equipment 310, may be transferred to the deposition equipment 320 through the buffer chamber.

The deposition equipment 320 may comprise a plurality of chambers. The plurality of chambers may comprise an organic light-emitting chamber, a cathode chamber, a buffer chamber, a flip chamber, an atomic layer deposition chamber ALD, a chemical vapor deposition chamber CVD, a stocker chamber Stk, an unloading chamber, etc.

The flip chamber, the atomic layer deposition chamber ALD, the chemical vapor deposition chamber CVD, the stocker chamber Stk, the unloading chamber, etc., may be installed in a ring shape with a robot arm in the center of the cluster chamber. The cluster chamber may be connected to the cathode chamber through the buffer chamber. The substrate may be transferred from the cathode chamber to the cluster chamber through the buffer chamber.

The organic light-emitting chamber is a member for forming an organic light-emitting layer composed of multiple layers, and may be connected to the patterning equipment. The organic light-emitting chamber is composed of a plurality of sub-chambers, and an organic light-emitting layer composed of multiple layers may be formed by passing through these plurality of sub-chambers. The plurality of sub-chambers may be arranged in an in-line manner. That is, the plurality of sub-chambers may be arranged in the same direction as the progress path of the substrate 100.

The cathode chamber may be a member for forming a cathode electrode. The cathode chamber may be connected to the organic light-emitting chamber. The cathode chamber may be arranged in the same direction as the progress path of the substrate 100. In addition to the cathode chamber, an additional cathode chamber for forming a cathode protective layer may be provided. The cathode chamber and the additional cathode chamber may be arranged in the same direction as the plurality of sub-chambers constituting the organic light-emitting chamber.

The buffer chamber may be a member for allowing the substrate 100, which has completed the process in the cathode chamber, to be transferred to a center where a robot arm is installed. The robot arm may transfer and return the substrate 100 received through the buffer chamber to the corresponding chamber according to a preset order.

The flip chamber may be a member for rotating the substrate 100.

The atomic layer deposition chamber ALD may be a member for depositing an oxide layer. The chemical vapor deposition chamber CVD may be a member for depositing a nitride layer, an oxide layer, or a nitride layer. First, an oxide film may be deposited through the atomic layer deposition chamber ALD, and then a nitride layer, an oxide layer, or a nitride layer may be deposited through the chemical vapor deposition chamber CVD. A multilayer film composed of an oxide film and a nitride film may be used as an insulating film for forming, for example, a first subpixel protective layer 151r (FIG. 17E), a second subpixel protective layer 151g (FIG. 17H), a third subpixel protective layer 151b (FIG. 17K), and a pixel protective layer 152 (FIG. 17M), respectively.

The unloading chamber may be a member for transporting the substrate 100, on which the deposition process in the chemical vapor deposition chamber CVD is completed, to the outside.

In order to deposit a pixel protective layer (152a of FIG. 17L) or an encapsulation layer (160 of FIG. 17Q) in the step n or the step t, the organic light-emitting chamber, the cathode chamber, etc., among the multiple chambers included in the deposition equipment 320 may be omitted.

Meanwhile, in FIG. 15, the steps p and q and the steps s and t may be performed in a structure similar to the manufacturing system of the organic light-emitting display device according to the embodiment illustrated in FIG. 16, respectively.

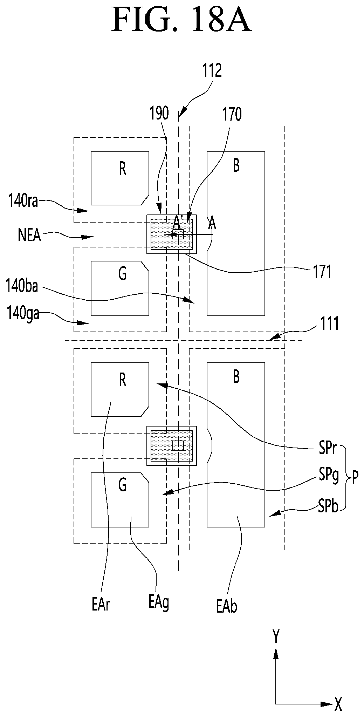

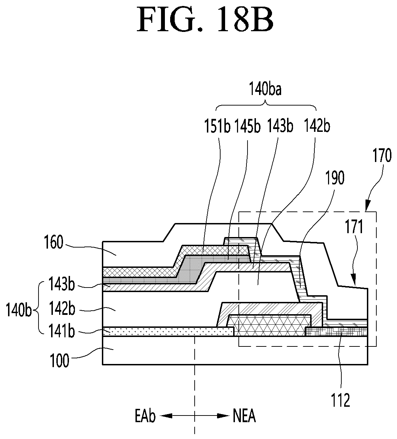

FIG. 18A and FIG. 18B are a plan view and a cross-sectional view of an organic light-emitting display device according to a fifteenth embodiment. Except for the power connecting structure in the structure illustrated in FIG. 18B, the remaining structure may be the same as the fourth embodiment to the sixth embodiment, the eighth embodiment, the ninth embodiment, and the twelfth embodiment to the fourteenth embodiment.

As illustrated in FIGS. 18A and 18B, the power connecting structure 170 may be installed in a three-way region where the first subpixel SPr, the second subpixel SPg, and the third subpixel SPb meet within one pixel P. In this instance, the bridge electrode 190 in the power connecting structure 170 may be directly connected to the first cathode connecting structure 181, the second cathode connecting structure 182, and the third cathode connecting structure 183 simultaneously. This connecting structure may be referred to as a three-way simultaneous connecting structure.

A bridge electrode 190 may be formed on a cathode-power simultaneous connecting structure (hereinafter, simultaneous connecting structure) that simultaneously connects the first cathode connecting structure 181, the second cathode connecting structure 182, the third cathode connecting structure 183, and the power connecting structure 170, so that they may be electrically connected therebetween. This structure may provide a structure capable of maximizing EAR in a high-resolution product.

Although not illustrated, the power connecting structure 170 may be disposed at a four-way intersection as illustrated in FIG. 2B, and the bridge electrode 190 in the power connecting structure 170 may be directly connected to the first cathode connecting structure 181, the second cathode connecting structure 182, and the third cathode connecting structure 183 simultaneously. This connecting structure may be called a four-way simultaneous connecting structure.

Meanwhile, when calculating the order of the size of the EAR for various possible connecting structures, it may decrease in the order of a four-way simultaneous connecting structure, a three-way simultaneous connecting structure (FIG. 18A), a four-way four-through-hole connecting structure (FIG. 10), and a three-way four-through-hole connecting structure (FIG. 2A). However, depending on whether an undercut occurs in the dry-etched cross-section when forming the through-hole, which type of power connecting structure 170 is applied may be determined among the types of power connecting structures 170.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

## Claims

1. A manufacturing system for an organic light-emitting display device for sequentially forming a first subpixel, a second subpixel, and a third subpixel constituting a pixel, comprising:
a first deposition equipment configured to sequentially deposit a first organic light-emitting film, a first cathode film, and a first insulating film on a substrate to form a first multilayer;
a first patterning equipment configured to pattern the formed first multilayer to form a first organic light-emitting element in an emission region of the first subpixel, and to form a first connecting pattern in a non-emission region of the first subpixel -the first organic light-emitting element comprising a first organic light-emitting layer and a first cathode electrode, and the first connecting pattern comprising a first extended organic light-emitting layer extended from the first organic light-emitting layer, a first extended cathode electrode extended from the first cathode electrode, and a first subpixel protection layer-; and
a second deposition equipment configured to sequentially deposit a second organic light-emitting film, a second cathode film, and a second insulating film on the patterned first organic light-emitting element and the first connecting pattern to form a second multilayer,
wherein the patterning of the first multilayer and the forming of the second multilayer are performed continuously in a vacuum atmosphere in the first patterning equipment and the second deposition equipment.

2. The manufacturing system of claim 1, wherein the second deposition equipment is configured to form the second multilayer on a lateral surface of the first extended cathode electrode exposed by the patterning of the first multilayer.

3. The manufacturing system of claim 1, wherein the first patterning equipment comprises:
a cluster chamber having a robot arm; and
a plurality of chambers installed in a ring shape around the cluster chamber and configured to pattern the formed first multilayer.

4. The manufacturing system of claim 1, wherein the second deposition equipment comprises:
an organic light-emitting chamber configured to be connected to the first patterning equipment, comprising a plurality of sub-chambers arranged in an in-line manner, and configured to deposit the second organic light-emitting film;
a cathode chamber installed in a same direction as the plurality of sub-chambers and configured to deposit the second cathode film;
a cluster chamber connected to the cathode chamber and having a robot arm; and
a plurality of chambers installed in a ring shape around the cluster chamber and configured to deposit the second insulating film.

5. The manufacturing system of claim 1, further comprise
a second patterning equipment configured to pattern the formed second multilayer to form a second organic light-emitting element in an emission region of the second subpixel, and to form a second connecting pattern in an non-emission region of the second subpixel -the second organic light-emitting element comprising a second organic light-emitting layer and a second cathode electrode, and the second connecting pattern comprising a second extended organic light-emitting layer extended from the second organic light-emitting layer, a second extended cathode electrode extended from the second cathode electrode, and a second subpixel protection layer-; and
a third deposition equipment configured to sequentially deposit a third organic light-emitting film, a third cathode film, and a third insulating film on the patterned second organic light-emitting element and the second connecting pattern to form a third multilayer,
wherein the patterning of the second multilayer and the forming of the third multilayer are performed continuously in a vacuum atmosphere in the second patterning equipment and the third deposition equipment.

6. The manufacturing system of claim 5, wherein the third patterning equipment is configured to form the third multilayer on a lateral surface of the second extended cathode electrode exposed by the patterning of the second multilayer.

7. The manufacturing system of claim 5, wherein the second patterning equipment comprises:
a cluster chamber having a robot arm; and
a plurality of chambers installed in a ring shape around the cluster chamber and configured to pattern the formed second multilayer.

8. The manufacturing system of claim 5, wherein the third patterning equipment comprises:
an organic light-emitting chamber connected to the second patterning equipment, comprising a plurality of sub-chambers arranged in an in-line manner, and configured to deposit the third organic light-emitting film;
a cathode chamber installed in a same direction as the plurality of sub-chambers and configured to deposit the third cathode film;
a cluster chamber connected to the cathode chamber and having a robot arm; and
a plurality of chambers installed in a ring shape around the cluster chamber and configured to deposit the third insulating film.

9. The manufacturing system of claim 5, further comprising:
a third patterning equipment configured to pattern the formed third multilayer to form a third organic light-emitting element in an emission region of the third subpixel, and to form a third connecting pattern in a non-emission region of the third subpixel -the third organic light-emitting element comprising a third organic light-emitting layer and a third cathode electrode, and the third connecting pattern comprising a third extended organic light-emitting layer extended from the third organic light-emitting layer, a third extended cathode electrode extended from the third cathode electrode, and a third subpixel protection layer-; and
a fourth deposition equipment configured to deposit a pixel protection layer on the patterned third organic light-emitting element and the third connecting pattern,
wherein the patterning of the third multilayer and the deposition of the pixel protection layer are performed continuously in a vacuum atmosphere in the third patterning equipment and the fourth deposition equipment.

10. The manufacturing system of claim 9, wherein the fourth deposition equipment is configured to form the pixel protection layer on a lateral surface of the first extended cathode electrode, a lateral surface of the second extended cathode electrode, and a lateral surface of the third extended cathode electrode exposed by the patterning of the third multilayer.

11. The manufacturing system of claim 9, wherein the third patterning equipment comprises:
a cluster chamber having a robot arm; and
a plurality of chambers installed in a ring shape around the cluster chamber and configured to pattern the formed third multilayer.

12. The manufacturing system of claim 9, further comprising:
a fourth patterning equipment configured to pattern the pixel protection layer and the first subpixel protection layer to the third subpixel protection layer to form a power contact hole of a power connecting structure in which power wiring is exposed and a first cathode contact hole to a third cathode contact hole in which the first extended cathode electrode to the third extended cathode electrode are exposed; and
a fifth deposition equipment configured to deposit a bridge electrode on the substrate comprising the power contact hole and the first cathode contact hole to the third cathode contact hole,
wherein the patterning of the pixel protection layer and the deposition of the bridge electrode are performed continuously in a vacuum atmosphere in the fourth patterning equipment and the fifth deposition equipment.

13. The manufacturing system of claim 12, wherein the fifth patterning equipment is configured to form the bridge electrode on an upper surface of the first extended cathode electrode, a lateral surface of the second extended cathode electrode, and a lateral surface of the third extended cathode electrode, which are exposed through the power contact hole and the first cathode contact hole to the third cathode contact hole, by patterning the pixel protection layer.

14. The manufacturing system of claim 12, further comprising:
a fifth patterning equipment configured to pattern the bridge electrode; and
a sixth patterning equipment configured to deposit an encapsulation layer on the substrate comprising the patterned bridge electrode,
wherein the patterning of the bridge electrode and the deposition of the encapsulation layer are performed continuously in a vacuum atmosphere in the fifth patterning equipment and the sixth patterning equipment.

15. The manufacturing system of claim 9, wherein the first subpixel protection layer, the second subpixel protection layer, and the third subpixel protection layer are formed in the emission region of the first subpixel, the emission region of the second subpixel, and the emission region of the third subpixel, respectively.

16. A manufacturing method for an organic light-emitting display device for sequentially forming a first subpixel, a second subpixel, and a third subpixel constituting a pixel, comprising:
sequentially depositing a first organic light-emitting film, a first cathode film, and a first insulating film on a substrate to form a first multilayer;
patterning the formed first multilayer to form a first organic light-emitting element in the emission region of the first subpixel, and to form a first connecting pattern in the non-emission region of the first subpixel -the first organic light-emitting element comprising a first organic light-emitting layer and a first cathode electrode, and the first connecting pattern comprising a first extended organic light-emitting layer extended from the first organic light-emitting layer, a first extended cathode electrode extended from the first cathode electrode, and a first subpixel protection layer-; and
sequentially depositing a second organic light-emitting film, a second cathode film, and a second insulating film on the patterned first organic light-emitting element and the first connecting pattern to form a second multilayer,
wherein the patterning of the first multilayer and the film formation of the second multilayer are performed continuously in a vacuum atmosphere.

17. The manufacturing method of claim 16, wherein the forming the second multilayer comprises:
forming the second multilayer on a lateral surface of the first extended cathode electrode exposed by the patterning of the first multilayer.

18. The manufacturing method of claim 16, further comprising:
patterning the formed second multilayer to form a second organic light-emitting element in an emission region of the second subpixel, and to form a second connecting pattern in a non-emission region of the second subpixel -the second organic light-emitting element comprising a second organic light-emitting layer and a second cathode electrode, and the second connecting pattern comprising a second extended organic light-emitting layer extended from the second organic light-emitting layer, a second extended cathode electrode extended from the second cathode electrode, and a second subpixel protection layer-; and
sequentially depositing a third organic light-emitting film, a third cathode film, and a third insulating film on the patterned second organic light-emitting element and the second connecting pattern to form a third multilayer,
wherein the patterning of the second multilayer and the formation of the third multilayer are performed continuously in a vacuum atmosphere.

19. The manufacturing method of claim 18, wherein the forming the third multilayer comprises:
forming the third multilayer on a lateral surface of the second extended cathode electrode exposed by the patterning of the second multilayer.

20. The manufacturing method of claim 18, further comprising:
patterning the formed third multilayer to form a third organic light-emitting element in an emission region of the third subpixel, and to form a third connecting pattern in a non-emission region of the third subpixel -the third organic light-emitting element comprising a third organic light-emitting layer and a third cathode electrode, and the third connecting pattern comprising a third extended organic light-emitting layer extended from the third organic light-emitting layer, a third extended cathode electrode extended from the third cathode electrode, and a third subpixel protection layer-; and
depositing a pixel protection layer on the patterned third organic light-emitting element and the third connecting pattern,
wherein the patterning of the third multilayer and the deposition of the pixel protection layer are performed continuously in a vacuum atmosphere.

21. The manufacturing method of claim 20, wherein the forming the pixel protection layer comprises:
forming the pixel protection layer on a lateral surface of the first extended cathode electrode, a lateral surface of the second extended cathode electrode, and a lateral surface of the third extended cathode electrode exposed by the patterning of the third multilayer.

22. The manufacturing method of claim 20, further comprising:
patterning the pixel protection layer and the first subpixel protection layer to the third subpixel protection layer to form a power contact hole of a power connecting structure in which power wiring is exposed and a first cathode contact hole to a third cathode contact hole in which the first extended cathode electrode to the third extended cathode electrode are exposed; and
depositing bridge electrode on the substrate comprising the power contact hole and the first cathode contact hole to the third cathode contact hole,
wherein the patterning of the pixel protection layer and the deposition of the bridge electrode are performed continuously in a vacuum atmosphere.

23. The manufacturing method of claim 22, wherein the forming the bridge electrode comprises:
forming the bridge electrode on an upper surface of the first extended cathode electrode, a lateral surface of the second extended cathode electrode, and a lateral surface of the third extended cathode electrode, which are exposed through the power contact hole and the first cathode contact hole to the third cathode contact hole, by patterning the pixel protection layer.

24. The manufacturing method of claim 22, further comprising:
patterning the bridge electrode; and
forming an encapsulation layer on the substrate comprising the patterned bridge electrode,
wherein the patterning of the bridge electrode and the deposition of the encapsulation layer are performed continuously in a vacuum atmosphere.
